# EUROPEAN PATENT APPLICATION

(11) **EP 4 776 807 A1**
(43) Date of publication of application: **15.07.2026**
(21) Application number: 26150426.0
(22) Date of filing: 06.01.2026
(51) Int. Cl.: H10K 59/122, H10K 59/35, H10K 59/80

(54) **LIGHT EMITTING DISPLAY DEVICE AND ELECTRONIC DEVICE**

(30) Priority: 08.01.2025 KR 20250002570; 18.03.2025 KR 20250034964
(71) Applicant: Samsung Display Co., Ltd., Yongin-si, Gyeonggi-do 17113 (KR)
(72) Inventor: CHOI, Kook Hyun, 17113 Yongin-si (KR); KIM, Changwook, 17113 Yongin-si (KR); PARK, Sungjae, 17113 Yongin-si (KR); IM, Choongyoul, 17113 Yongin-si (KR); CHO, Jaebum, 17113 Yongin-si (KR); CHOI, Beohmrock, 17113 Yongin-si (KR); CHOI, Sujin, 17113 Yongin-si (KR)
(74) Representative: Taor, Simon Edward William

(57) **Abstract**

A light emitting display device according to an embodiment includes a display area where a plurality of repeating unit pixels are iteratively provided, the repeating unit pixel includes a plurality of minimum unit pixels, the minimum unit pixel includes at least one red subpixel, at least one green subpixel, and at least one blue subpixel, the green subpixel, the red subpixel, and the blue subpixel correspond to a first opening provided in a pixel defining layer and a second opening provided above the first opening while corresponding to the first opening, at least one of the first opening and the second opening has an elliptical shape in planar shape, and the repeating unit pixel is formed of minimum unit pixels provided in a 2x2 array.

## Description

### CROSS-REFERENCE TO RELATED APPLICATION

The present application claims priority to and the benefit of Korean Patent Application Nos. 10-2025-0002570 and 10-2025-0034964 filed with the Korean Intellectual Property Office on January 8, 2025 and March 18, 2025, respectively.

### BACKGROUND

### 1. Field

Embodiments of the present disclosure relate to a light emitting display device and an electronic device.

### 2. Description of the Related Art

A display device is a device that displays a screen (e.g., an image and/or moving images), and may include a liquid crystal display (LCD) and/or an organic light emitting diode (OLED) display device. Such a display device is used in various suitable electronic devices such as a portable phone, a navigation device, a digital camera, an electronic book, a portable game device, and/or various suitable terminals.

A display device such as an OLED display device may use a flexible substrate, and thus may have a structure that the display device is bendable and/or foldable.

In addition, in a small electronic device such as a portable phone, an optical element such as cameras and/or an optical sensor may be formed in a bezel region around (e.g., surrounding) the display area, but as the size of the displayed screen is made larger and the size of the peripheral area of the display device is reduced, technologies that can place the camera and/or the optical sensor on the back of the display area are being investigated.

### SUMMARY

Embodiments of the present disclosure are intended to reduce a diffraction pattern that occurs when external light is reflected. Embodiments provide a light emitting display device formed so as not to cause stains due to reflection of external light or a phenomenon in which the reflectance of external light differs depending on an angle (e.g., an angle with respect to a source of light).

Embodiments of the present disclosure provide a light emitting display device in which a light blocking layer having a black color is on a front of a display panel or a plurality of color filters are overlapped instead of including the light blocking layer to prevent or reduce external light from being reflected and/or transmitted, thereby reducing stains that occur or reducing a difference in reflectance according to the angle of external light (e.g., an angle of incidence of the external light).

A light emitting display device according to an embodiment includes a display area where a plurality of repeating unit pixels are iteratively provided or formed, the repeating unit pixel includes a plurality of minimum unit pixels, each of the plurality of minimum unit pixels includes at least one red subpixel, at least one green subpixel, and at least one blue subpixel, the at least one green subpixel, the at least one red subpixel, and the at least one blue subpixel corresponding to a first opening provided in a pixel defining layer and a second opening provided above the first opening while corresponding to the first opening, at least one selected from the first opening and the second opening has an elliptical shape (e.g., a generally elliptical shape) in planar shape (e.g., in a plan view), and each of the plurality of repeating unit pixels is formed of the minimum unit pixels provided in a 2x2 array.

Each of the minimum unit pixels may be formed of four of the green subpixels (e.g., the at least one green subpixel includes four green subpixels), two of the red subpixels (e.g., the at least one red subpixel includes two red subpixels), and two of the blue subpixels (e.g., the at least one blue subpixel includes two blue subpixels).

A first square may be formed by connecting the four green subpixels with horizontal and vertical straight lines (e.g., by connecting four adjacent ones of the green subpixels with the horizontal and vertical straight lines such that the four green subpixels are at respective vertices of the first square), and a second square may be formed by connecting the two red subpixels and the two blue subpixels with horizontal and vertical straight lines (e.g., by connecting adjacent two adjacent ones of the red subpixels and two adjacent ones of the blue subpixels with the horizontal and vertical straight lines such that the two red subpixels and the two blue subpixels are at respective vertices of the second square).

The at least one red subpixel or the at least one blue subpixel may be provided at a center of the first square formed of the four green subpixels, and the green subpixel may be provided at a center of the second square formed of the two red subpixels and the two blue subpixels.

The first opening and the second opening, which correspond to the at least one green subpixel, the at least one red subpixel, and the at least one blue subpixel, respectively, may have an elliptical shape (e.g., a generally elliptical shape) in planar shape (e.g., in a plan view), and a major axis direction of the second opening may have an angular difference of 45*n degrees (where n is a natural number greater than or equal to 1 and less than or equal to 8) from a major axis direction of an adjacent second opening of the same color.

In the repeating unit pixel, the second opening corresponding to the red subpixel and the second opening corresponding to the blue subpixel may have a major axis direction angle difference of 90 degrees and may be provided alternately along a single diagonal direction.

In the repeating unit pixel, the major axis directions of the second opening corresponding to the at least one red subpixel and the second opening corresponding to the at least one blue subpixel may be provided at directions of 0 degree and 90 degrees and 45 degrees and 135 degrees alternately along a single diagonal direction.

In the repeating unit pixel, among the second openings corresponding to the at least one green subpixel, second openings having a 90 degree difference in the major axis direction may be provided alternately along the horizontal direction or the vertical direction.

In the repeating unit pixel, the major axis direction angles of the second opening corresponding to the at least one green subpixel may be provided alternately along the horizontal direction or the vertical direction, at directions of 0 degree and 90 degrees and 45 degrees and 135 degrees.

The minimum unit pixel may be formed of one green subpixel, one red subpixel, and one blue subpixel.

A triangle may be formed by connecting the one green subpixel, the one red subpixel, and the one blue subpixel in a straight line (e.g., with three straight lines).

The first opening and the second opening, which correspond to the at least one green subpixel, the at least one red subpixel, and the at least one blue subpixel respectively, may have an elliptical shape (e.g., a generally elliptical shape) in planar shape (e.g., in a plan view), and the major axis direction of the second opening may have an angular difference of 45*n degrees (where n is a natural number greater than or equal to 1 and less than or equal to 8) from a major axis direction of an adjacent second opening of the same color.

In the repeating unit pixel, among the second openings corresponding to the at least one red subpixel, the at least one green subpixel, and the at least one blue subpixel, second openings having a 90 degree difference in the major axis direction may be provided alternately along the horizontal direction or the vertical direction.

In the repeating unit pixel, the major axis direction angles of the second opening corresponding to the at least one red subpixel, the at least one green subpixel, and the at least one blue subpixel may be provided alternately along the horizontal direction or the vertical direction, at directions of 0 degree and 90 degrees and 45 degrees and 135 degrees.

At least one selected from the first opening and the second opening may have a circular shape (e.g., a generally circular shape) in planar shape (e.g., in a plan view).

The second opening may be on the light blocking layer that is provided above the pixel defining layer, or on a light blocking region of an overlapping color filter.

An electronic device according to an embodiment includes a light emitting display device, wherein the light emitting display device includes a display area where a plurality of repeating unit pixels are iteratively provided, the repeating unit pixel includes a plurality of minimum unit pixels, the minimum unit pixel includes at least one red subpixel, at least one green subpixel, and at least one blue subpixel, the at least one green subpixel, the at least one red subpixel, and the at least one blue subpixel may correspond to a first opening provided in a pixel defining layer and a second opening provided above the first opening while corresponding to the first opening, at least one selected from the first opening and the second opening may have an elliptical shape (e.g., a generally elliptical shape) in planar shape (e.g., in a plan view), and the repeating unit pixel may be formed of minimum unit pixels provided in a 2x2 array.

The minimum unit pixel may be formed of four of the green subpixels (e.g., the at least one green subpixel includes four green subpixels), two of the red subpixels (e.g., the at least one red subpixel includes two red subpixels), and two of the blue subpixels (e.g., the at least one green subpixel includes two blue subpixels).

A first square may be formed by connecting the four green subpixels with horizontal and vertical straight lines (e.g., by connecting four adjacent ones of the green subpixels with the horizontal and vertical straight lines such that the four green subpixels are at respective vertices of the first square), and a second square is formed by connecting the two red subpixels and the two blue subpixels with horizontal and vertical straight lines (e.g., by connecting adjacent two adjacent ones of the red subpixels and two adjacent ones of the blue subpixels with the horizontal and vertical straight lines such that the two red subpixels and the two blue subpixels are at respective vertices of the second square).

The at least one red subpixel or the at least one blue subpixel may be provided at a center of the first square formed of the four green subpixels, and the green subpixel may be provided at a center of the second square formed of the two red subpixels and the two blue subpixels.

According to an aspect, there is provided a light emitting display device as set out in claim 1. Additional features are set out in claims 2 to 14. According to an aspect, there is provided an electronic device as set out in claim 15.

According to the embodiments, instead of a polarizing plate, a black pixel defining layer can be used to separate the light emitting layers from each other, thereby reducing a ratio (or amount) of reflected external light and reducing the staining caused by external light. According to embodiments, the number of minimum unit pixels included in an repeating unit pixel that is repeatedly provided in the display area can be reduced, for example, to a 2x2 array, to reduce staining caused by external light. According to embodiments, even if the number of minimum unit pixels included in the repeating unit pixels repeatedly provided in the display area is relatively large, such as a 4x4 array, the difference in the reflectance value of external light according to an angle (e.g., an angle of incidence of the external light) can be similar within a set or certain range such that the difference in reflectance of external light is not recognized by the user.

According to embodiments, because a polarizing plate is not used, the luminance is not reduced when passing through the polarizing plate, and thus the maximum luminance value of the light emitting display device is formed to be more than 2500 Nit, thereby providing a bright light emitting display device.

### BRIEF DESCRIPTION OF THE DRAWINGS

The accompanying drawings, together with the specification, illustrate embodiments of the subject matter of the present disclosure, and, together with the description, serve to explain principles of embodiments of the subject matter of the present disclosure.
FIG. 1 is a schematic perspective view of a use state of a display device according to an embodiment.
FIG. 2 is an exploded perspective view of a display device according to an embodiment.
FIG. 3 is a block diagram of a display device according to an embodiment.
FIG. 4 is a perspective view that schematically illustrates a light emitting display device according to another embodiment.
FIG. 5 is a top plan view that is an enlarged view of a region of a light emitting display device according to an embodiment.
FIG. 6 is a schematic cross-sectional view of a display panel according to an embodiment.
FIG. 7 and FIG. 8 are top plan views of a minimum unit pixel provided in a display panel according to an embodiment.
FIG. 9 to FIG. 17 show an repeating unit pixel provided in a display panel according to an embodiment.
FIG. 18 is a table that summarizes the characteristics of reflected light for some embodiments.
FIG. 19 show major axis angles of second openings of a light blocking layer corresponding to a red subpixel of a first repeating unit pixel provided in a display panel according to an embodiment.
FIG. 20A to FIG. 20C show repeating unit pixels provided in a display panel according to an embodiment.
FIG. 21 to FIG. 26 show an repeating unit pixel provided in a display panel.
FIG. 27 is a table that summarizes the characteristics of reflected light for some embodiments.
FIG. 28 shows a major axis angle of a second opening of a light blocking layer corresponding to one subpixel of the second repeating unit pixel on a display panel according to an embodiment.
FIG. 29 shows an repeating unit pixel provided in a display panel according to an embodiment.
FIG. 30 to FIG. 35 show features of display panels according to embodiments.
FIG. 36 and FIG. 37 are schematic cross-sectional views of display panels according to embodiments.
FIG. 38 is a graph that shows transmittance according to a wavelength of the color filter.
FIG. 39 and FIG. 40 are cross-sectional views of light emitting display devices according to embodiments.

### DETAILED DESCRIPTION

Hereinafter, embodiments of the present disclosure are described in more detail with reference to the accompanying drawings and so that a person of ordinary skill in the technical field to which the present disclosure belongs can easily practice the subject matter of the present disclosure. As those skilled in the art would realize, the described embodiments may be modified in various suitable different ways, all without departing from the scope of the present disclosure.

In order to clearly describe the subject matter of the present disclosure, certain parts that may be irrelevant to the description may be omitted, and the same reference numerals are used for identical or similar components throughout the specification.

In embodiments, the size and thickness of each component shown in the drawing may be arbitrarily shown for better understanding and ease of description, and therefore the present disclosure is not necessarily limited to what is shown. In the drawings, the thickness of layers, films, panels, regions, and the like may be exaggerated for clarity. In embodiments, in the drawings, for better understanding and ease of description, the thickness of some layers and regions may be exaggerated.

It will be understood that when an element such as a layer, film, region, or substrate is referred to as being "on" another element, it can be directly on the other element or intervening elements may also be present therebetween. In contrast, when an element is referred to as being "directly on" another element, there are no intervening elements present. Further, throughout the specification, the word "on" a target element will be understood to be above or below the target element, and will not necessarily be understood to be "at an upper side" based on an opposite to gravity direction.

In embodiments, unless explicitly described to the contrary, the words "comprise" and "include," and variations thereof such as "comprises" "comprising," "includes," and "including," will be understood to imply the inclusion of stated elements but not the exclusion of any other elements.

Further, throughout the specification, the phrases "planar," "planar shape," "on a plane," or "in a plan view" mean viewing a target portion from the top, and the phrase "on a cross-section" means viewing a cross-section formed by vertically cutting a target portion from the side.

In embodiments, throughout the specification, when "connected to" in the entire specification, this does not only mean that two or more constituent elements are directly connected, but also means that two or more constituent elements are indirectly connected, physically connected, and electrically connected through other constituent elements, or being referred to by different names depending on the position or function, while being integral.

In embodiments, throughout the specification, when a part such as a wire, layer, film, region, plate, or component is described to "extend in a first direction or second direction," this does not only mean a straight line shape that extends straight in that direction, but also a structure that extends overall along the first direction or second direction, and also includes a structure that extends while being bent at some part, having a zigzag structure, or including a curved line structure.

In embodiments, an electronic device (e.g., a mobile phone, a TV, a monitor, a laptop computer, and/or the like) that includes a display device, a display panel, and/or the like described in the specification, or an electronic device that includes a display device, a display panel, and the like manufactured by a manufacturing method described in the specification, are not excluded from the scope of rights of this specification.

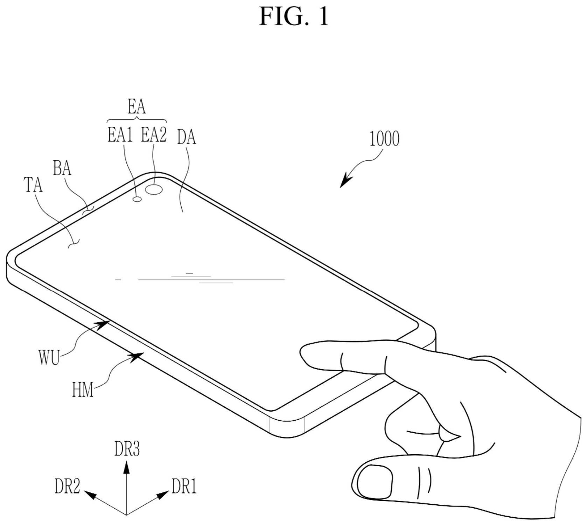

Hereinafter, a structure of a schematic display device will be described with reference to FIG. 1 to FIG. 3.

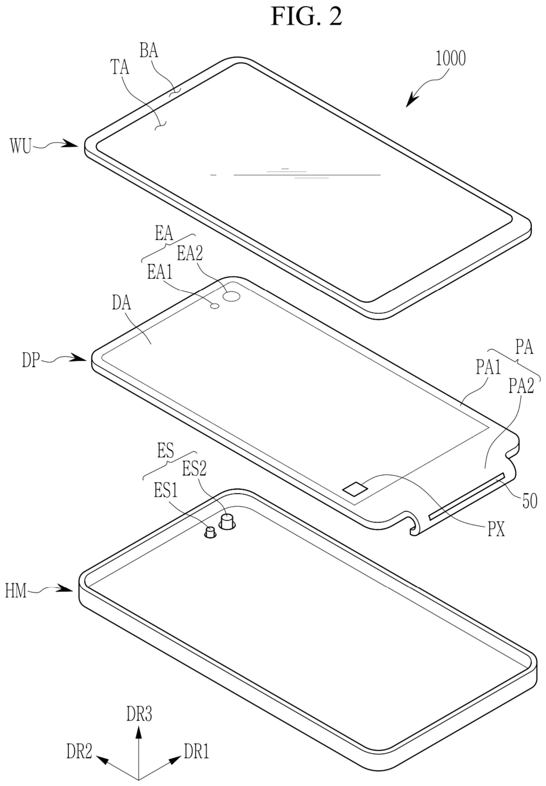

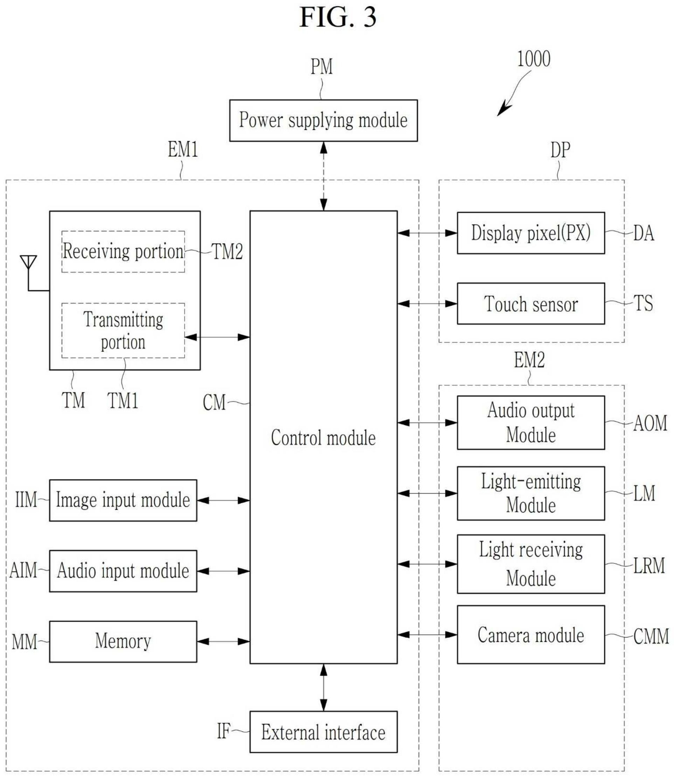

FIG. 1 is a schematic perspective view of a use state of a display device according to an embodiment, FIG. 2 is an exploded perspective view of a display device according to an embodiment, and FIG. 3 is a block diagram of a display device according to an embodiment.

Referring to FIG. 1, a display device 1000 according to an embodiment is a device that displays a motion picture (e.g., a moving image) and/or a still image, and may be used as a display screen of various suitable products such as a portable electronic device such as a mobile phone, a smart phone, a tablet personal computer (PC), a mobile communication terminal, an electronic notebook, an electronic book, a portable multimedia player (PMP), a navigation, an ultra mobile PC (UMPC), and/or the like, a television, a laptop, a monitor, a signboard, an internet of things (IOT) device, and/or the like. In embodiments, the display device 1000 according to an embodiment may be used in a wearable device such as a smart watch, a watch phone, a spectacles-type display, and a head mounted display (HMD). In embodiments, the display device 1000 according to an embodiment may be used as a center information display (CID) on an instrument panel of a vehicle, a center fascia and/or dashboard of a vehicle, a room mirror display replacing a side mirror of a vehicle, and a display on the back of a front seat as entertainment for the rear seats of a vehicle. For better comprehension and ease of description, FIG. 1 shows that the display device 1000 is used as a smart phone, but embodiments of the present disclosure are not limited thereto.

The display device 1000 may display an image toward a third direction DR3 on a display plane that is parallel (e.g., substantially parallel) with a first direction DR1 and a second direction DR2. The display plane where an image is displayed may correspond to a front surface of the display device 1000, and may correspond to a front surface of a cover window WU. The image may include a dynamic image and/or a still image.

In the present embodiment, a front surface (or upper surface) and a rear surface (or bottom surface) of each member are defined with reference to a direction where an image is displayed. The front surface and the rear surface are opposed to each other in the third direction DR3, and the normal direction of each of the front surface and the rear surface may be parallel (e.g., substantially parallel) to the third direction DR3. A distance between the front surface and the rear surface in the third direction DR3 may correspond to a thickness of a display panel in the third direction DR3.

The display device 1000 according to an embodiment may detect a user's input (refer to the hand in FIG. 1) applied from outside. The user's input may include various suitable types or kinds of external input such as a part of the user's body, light, heat, and/or pressure. In an embodiment, the user's input is illustrated as the user's hand being applied to the front surface. However, embodiments of the present disclosure are not limited thereto. The user's input maybe provided in various suitable forms, and also, depending on a structure of the display device 1000, the display device 1000 may detect a user input applied to a side surface or the rear surface of the display device 1000.

Referring to FIG. 1 and FIG. 2, the display device 1000 may include a cover window WU, a housing HM, a display panel DP, and an optical element ES. In an embodiment, the cover window WU and the housing HM may be combined to form the appearance of the display device 1000.

The cover window WU may include an insulating panel (e.g., an electrically insulating panel). For example, the cover window WU may be formed of glass, plastic (e.g., polymer), or a combination thereof.

A front surface of the cover window WU may define the front surface of the display device 1000. A transmissive area TA may be optically transparent area. For example, the transmissive area TA may be an area having a visible light transmittance of about 90% or more.

A blocking area BA may define the shape of the transmissive area TA. The blocking area BA may be adjacent to the transmissive area TA and may be around (e.g., surround) the transmissive area TA. The blocking area BA may be a region having relatively low light transmittance compared to the transmissive area TA. The blocking area BA may include an opaque material that blocks or reduces transmission of light. The blocking area BA may have a set or predetermined color. The blocking area BA may be defined by a bezel layer that is separately provided from a transparent substrate that defines the transmissive area TA, or may be defined by an ink layer that is formed by insertion and/or coloring on a transparent substrate.

The display panel DP may include a display pixel PX that displays an image and a driver 50, and the display pixel PX is provided in the display area DA and the component area EA. The display panel DP may include a front surface that includes a display area DA and a non-display area PA. In an embodiment, the display area DA and the component area EA are areas where pixels are included and thus an image is displayed, and at the same time, may be areas where a touch sensor is provided at an upper side in the third direction DR3 and thus an external input is sensed.

The transmissive area TA of the cover window WU may be at least partially overlapped with the display area DA and the component area EA of the display panel DP. For example, the transmissive area TA may overlap the front surface of the display area DA and component area EA, or may overlap at least a part of the display area DA and the component area EA. Accordingly, a user may view an image through the transmissive area TA and/or provide an external input based on the image. However, embodiments of the present disclosure are not limited thereto. For example, a region where an image is displayed and a region where an external input is sensed may be separated from each other.

The non-display area PA of the display panel DP may overlap at least a part of the blocking area BA of the cover window WU. The non-display area PA may be a region covered by the blocking area BA. The non-display area PA may be adjacent to the display area DA, and may be around (e.g., surround) the display area DA. The non-display area PA does not display an image, and a driving circuit and/or driving wiring to drive the display area DA may be provided in the non-display area PA. The non-display area PA may include a first peripheral area PA1 and a driver 50 provided outside the display area DA, and a second peripheral area PA2 including connection wiring and a bending area. In the embodiment of FIG. 2, the first peripheral area PA1 is provided at three sides of the display area DA, and the second peripheral area PA2 is provided at the remaining one side.

In an embodiment, the display panel DP may be assembled in a state that the display area DA, the component area EA, and the non-display area PA are flat toward the cover window WU. However, embodiments of the present disclosure are not limited thereto. The non-display area PA of the display panel DP may be partially bendable. In this embodiment, a part of the non-display area PA faces a rear surface of the display device 1000 and thus the blocking area BA viewed to the front surface of the display device 1000 may be reduced, and in FIG. 2, the second peripheral area PA2 may be assembled after being bent and provided on the rear surface of the display area DA.

In embodiments, the component area EA of the display panel DP may include a first component area EA1 and a second component area EA2. The first component area EA1 and the second component area EA2 may be at least partially around (e.g., surrounded by) the display area DA. The first component area EA1 and the second component area EA2 are illustrated as being separated from each other, but are not limited thereto and may at least be partially connected. The first component area EA1 and the second component area EA2 may be regions where optical elements (refer to ES in FIG. 2; also referred to as components hereinafter) that utilize infrared light, visible light, and/or sound are placed below them.

In the display area DA (hereinafter also referred to as a main display area) and the component area EA, a plurality of light emitting diodes and a plurality of pixel circuit portions may generate and transmit a light emitting current to the plurality of light emitting diodes. In embodiments, one light emitting diode and one pixel circuit portion are called a pixel PX. In the display area DA and component area EA, one pixel circuit portion and one light emitting diode may be formed one-to-one.

The first component area EA1 may include a display unit including a transparent portion that allows light and/or sound to pass through and a plurality of pixels. The transparent portion is formed of a layer between adjacent pixels and through which light and/or sound is transparent (e.g., transmitted). The transparent portion may be between adjacent pixels, and depending on embodiments, a layer through which light cannot be passed (e.g., substantially is not transmitted), such as a light blocking layer, may overlap the first component area EA1. The number of pixels per unit area (hereinafter referred to as resolution) of pixels (hereinafter referred to as normal pixels) included in the display area DA and the number of pixels per unit area of pixels included in the first component area EA1 (hereinafter referred to as first component pixels) may be the same.

The second component area EA2 includes an area formed of a transparent layer that allows light to pass through (hereinafter, also referred to as a light transmitting area), and the light transmitting area may have a structure in which a conductive layer (e.g., an electrically conductive layer) or a semiconductor layer is not provided, and a layer including a light blocking material, for example, a pixel defining layer and/or a light blocking layer includes an opening that overlaps a position corresponding to the second component area EA2, thereby not blocking light (e.g., substantially not blocking transmission of light). The number of pixels per unit area of a pixel included in the second component area EA2 (hereinafter, also referred to as a second component pixel) may be smaller than the number of pixels per unit area of a normal pixel included in the display area DA. As a result, the resolution of the second component pixel may be lower than the resolution of the normal pixel.

Depending on embodiments, a light blocking area overlapping at least two color filters is formed instead of the light blocking layer to block (or reduce transmission of) light of a set or specific wavelength band (e.g., visible light and/or the like).

Referring to FIG. 3, the display panel DP may further include a touch sensor TS in addition to the display area DA where the display pixel PX is included. The display panel DP may be viewed by the user from the outside through the transmissive area TA, including the pixel PX, which is a component that generates an image. In embodiments, the touch sensor TS may be above the pixel PX, and may sense an external input applied from the outside. The touch sensor TS may sense the externa input provided to the cover window WU.

Referring back to FIG. 2, the second peripheral area PA2 may include a bending portion. The display area DA and the first peripheral area PA1 may have a flat state in a state that is substantially parallel with a plane defined by the first direction DR1 and the second direction DR2, and one side of the second peripheral area PA2 may be extended from a flat state, pass through a bend, and then become flat again. As a result, at least a part of the second peripheral area PA2 may be assembled to be bent and provided on the rear surface of the display area DA. When being assembled, at least a part of the second peripheral area PA2 overlaps the display area DA on a plane, and therefore the light blocking area BA of the display device 1000 may be reduced. However, embodiments of the present disclosure are not limited thereto. For example, the second peripheral area PA2 may not be bent.

The driver 50 may be mounted on the second peripheral area PA2, or may be mounted on the bending portion or provided at one of opposite sides of the bending portion. The driver 50 may be provided in chip form.

The driver 50 is electrically connected to the display area DA and the component area EA and may transmit an electrical signal to pixels of the display area DA and the component area EA. For example, the driver 50 may provide data signals to pixels PX provided in the display area DA. In embodiments, the driver 50 may include a touch driving circuit, and may be electrically connected with the touch sensor TS provided in the display area DA and/or the component area EA. In embodiments, the driver 50 may be designed to include various suitable circuits in addition to the above-stated circuits and provide various suitable electrical signals to the display area DA.

In embodiments, a pad portion may be provided at an end of the second peripheral area PA2, and the display device 1000 may be electrically connected with a flexible printed circuit board (FPCB) including a driving chip by the pad portion. In embodiments, the driving chip provided in the flexible printed circuit board may include various suitable driving circuits to drive the display device 1000 or a connector for power supply. Depending on embodiments, a rigid printed circuit board (PCB) may be used instead of the flexible printed circuit board.

The optical element ES may be below the display panel DP. The optical element ES may include a first optical element ES1 overlapping the first component area EA1 and a second optical element ES2 overlapping the second component area EA2. The first optical element ES1 may also use infrared light, in which embodiments the first component area EA1 may have a layer that does not transmit light, such as a light blocking layer, that overlaps the first component area EA1.

The first optical element ES1 may be an electronic element that uses light and/or sound. For example, the first optical element ES1 may be a sensor that receives and utilizes light, such as an infrared sensor, a sensor that outputs and detects light and/or sound to measure distance and/or recognize fingerprints, a small lamp that outputs light, and/or a speaker that outputs sound. In embodiments of an electron element that utilizes light, it is possible to utilize light of various suitable wavelength bands, such as visible light, infrared light, and/or ultraviolet light.

The second optical element ES2 may be at least one selected from an IR camera, a dot projector, an IR illuminator, and a time-of-flight (ToF) sensor.

Referring to FIG. 3, the display device 1000 may include the display panel DP, a power supplying module PM, a first electron module EM1, and a second electron module EM2. The display panel DP, the power supplying module PM, the first electron module EM1, and the second electron module EM2 may be electrically connected with each other. FIG. 3 illustrates as an example a display pixel and a touch sensor TS provided in the display area DA among the configurations of the display panel DP.

The power supplying module PM may supply power utilized or required for the overall operation of the display device 1000. The power supplying module PM may include any suitable battery module.

The first electron module EM1 and the second electron module EM2 may include various suitable functional modules for operation of the display device 1000. The first electron module EM1 may be directly mounted on a mother board electrically connected with the display panel DP or mounted on a separate substrate and electrically connected to the mother board through a connector and/or the like.

The first electron module EM1 may include a control module CM, a wireless communication module TM, an image input module IIM, an audio input module AIM, a memory MM, and an external interface IF. Some of the modules may not be mounted on the motherboard, but may be electrically connected to the motherboard via the flexible printed circuit board connected thereto.

The control module CM may control the overall operation of the display device 1000. The control module CM may be a microprocessor. For example, the control module CM activates or deactivates the display panel DP. The control module CM may control other modules such as the image input module IIM or the audio input module AIM based on a touch signal received from the display panel DP.

The wireless communication module TM may transmit/receive a wireless signal to/from other terminal using a Bluetooth and/or a Wi-Fi line. The wireless communication module TM may transmit/receive a voice signal using a general communication line. The wireless communication module TM includes a transmitting portion TM1 that modulates a signal to be transmitted and transmits the modulated signal, and a receiving portion TM2 demodulating a received signal.

The image input module IIM may process a video signal and convert to image data displayable in the display panel DP. The audio input module AIM may receive an external audio signal from a microphone in a recording mode, a voice recognition mode, and/or the like and convert the external audio signal into electrical voice data.

The external interface IF may serve as an interface connected to an external charger, a wired/wireless data port, a card socket (e.g., memory card, SIM/UIM card), and/or the like.

The second electron module EM2 may include an audio output module AOM, a light emitting module LM, a light receiving module LRM, a camera module CMM, and/or the like, and at least some of them may be on the rear surface of the display panel DP as shown in FIG. 1 and FIG. 2. As the optical element ES, the light emitting module LM, the light receiving module LRM, and the camera module CMM may be included. In embodiments, the second electron module EM2 may be directly mounted on the mother board, mounted on a separate substrate and electrically connected with the display panel DP through a connector, or electrically connected with the first electron module EM1.

The audio output module AOM may convert audio data received from the wireless communication module TM and/or stored in the memory MM and output the converted data to the outside.

The light emitting module LM may generate and output light. The light emitting module LM may output an infrared light. For example, the light emitting module LM may include an LED element. For example, the light receiving module LRM may sense an infrared light. The light receiving module LRM may be activated when infrared light above a set certain level is detected. The light receiving module LRM may include a complementary metal oxide semiconductor (CMOS) sensor. After an infrared light generated from the light emitting module LM is output, the infrared light is reflected by an external object (e.g., user's finger and/or face), and the reflected infrared light may be incident on the light receiving module LRM. The camera module CMM may capture an image of the outside.

In an embodiment, the optical element ES may additionally include a light detection sensor and/or heat detection sensor. The optical element ES may detect an external object received through the front surface or provide a sound signal such as voice to the outside through the front surface. In embodiments, the optical element ES may include a plurality of constituent elements, and is not limited to any one embodiment.

Referring back to FIG. 2, the housing HM may be combined with the cover window WU. The cover window WU may be on the front surface of the housing HM. The housing HM is combined with the cover window WU and provides a set or predetermined receiving space. The display panel DP and the optical element ES may be received in the set or predetermined receiving space provided between the housing HM and the cover window WU.

The housing HM may include a material having relatively high stiffness. For example, the housing HM may include glass, plastic (e.g., polymer), and/or a metal, and/or may include a plurality of frames and/or plates formed of a combination of glass, plastic (e.g., polymer), and a metal. The housing HM may stably protect constituent elements of the display device 1000, received in the internal space from an external impact.

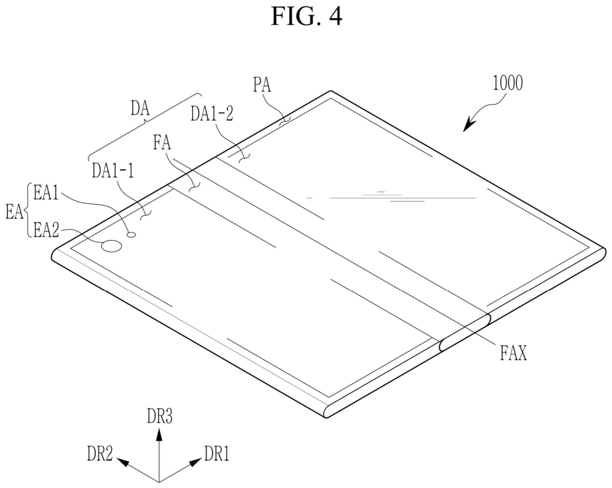

Hereinafter, a structure of a display device 1000 according to another embodiment will be described with reference to FIG. 4.

FIG. 4 is a perspective view that schematically illustrates a light emitting display device according to another embodiment.

A description of the same configuration as the aforementioned component may not be repeated here, and the embodiment of FIG. 4 illustrates a foldable display device having a structure in which the display device 1000 is folded via a folding axis FAX.

Referring to FIG. 4, in an embodiment, the display device 1000 may be a foldable display device. The display device 1000 may be folded outward and/or inward using the folding axis FAX as a reference. When being folded outward with reference to the folding axis FAX, a display plane of the display device 1000 may be provided at outer sides in the third direction DR3 such that an image may be displayed in both directions. When being folded inward with the folding axis FAX as a reference, the display surface may not be visible from the outside.

In an embodiment, the display device 1000 may include a display area DA, a component area EA, and a non-display area PA. The display area DA may be divided into a 1-1 display area DA1-1, a 1-2 display area DA1-2, and a folding area FA. The 1-1 display area DA1-1 and the 1-2 display area DA1-2 may be provided at the left side and the right side with reference to the folding axis FAX, and the folding area FA may be between the 1-1 display area DA1-1 and the 1-2 display area DA1-2. In this embodiment, when being folded outward with reference to the folding axis FAX, the 1-1 display area DA1-1 and the 1-2 display area DA1-2 are provided at opposite sides along the third direction DR3 such that an image may be displayed in both directions. In embodiments, when being folded inward, the 1-1 display area DA1-1 and the 1-2 display area DA1-2 may not be viewed from the outside.

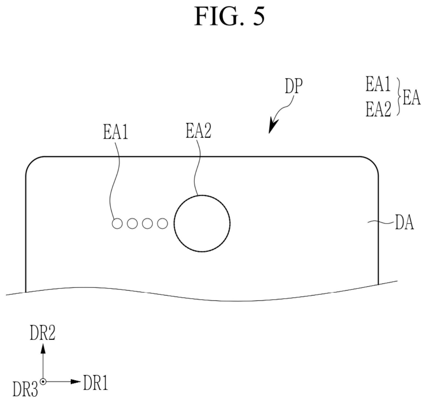

FIG. 5 is a top plan view that is an enlarged view of a region of a light emitting display device according to an embodiment.

FIG. 5 illustrates a part of a light emitting display panel DP of a light emitting display device according to an embodiment, and a display panel for a mobile phone is used, but embodiments of the present disclosure are not limited thereto.

A display area DA is provided in a front surface of the light emitting display panel DP, and a component area EA is also provided in the display area DA. In embodiments, the component area EA may include a first component area EA1 and a second component area EA2. In the embodiment of FIG. 5, the first component area EA1 is provided in a position adjacent to the second component area EA2. In the embodiment of FIG. 5, the first component area EA1 is provided at the left side of the second component area EA2. The position and the number of first component area EA1 may suitably vary depending on embodiments. In FIG. 5, a second optical element ES2 corresponding to the second component area EA2 may be a camera, and a first optical element ES1 corresponding to the first component area EA1 may be an optical sensor.

In the display area DA, a plurality of light emitting diodes, and a plurality of pixel circuit portions that generate and transmit a light emitting current to the plurality of light emitting diodes respectively are provided. In embodiments, one light emitting diode and one pixel circuit portion form a pixel PX. One pixel circuit portion and one light emitting diode may be formed one-to-one in the display area DA. The display area DA will be also referred to as a normal display area. In FIG. 5, a structure of the light emitting display panel DP below the cut line is not illustrated, but a display area DA may be below the cut line.

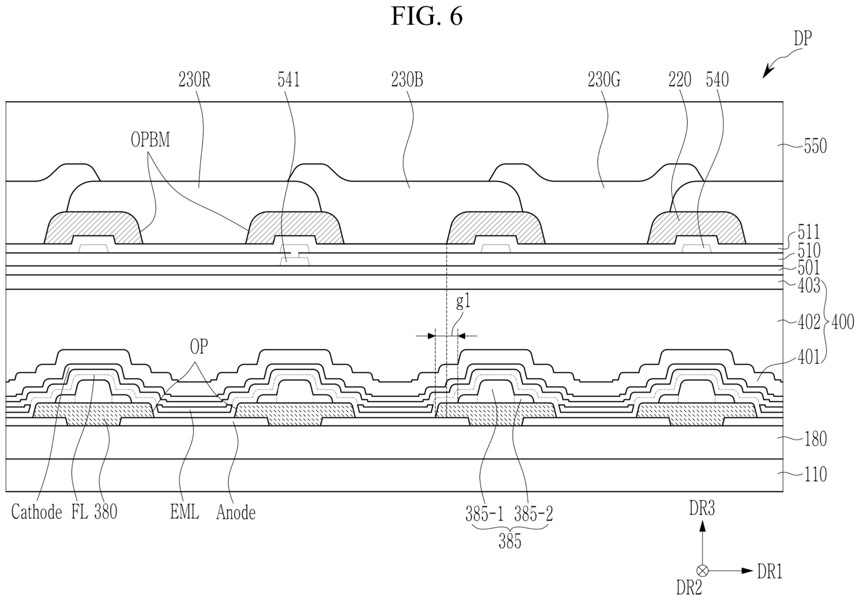

The light emitting display panel DP according to the embodiment may be divided into a lower panel layer and an upper panel layer. The lower panel layer is a power where the light emitting diode and the pixel circuit portion that form the pixel are provided, and may include an encapsulation layer (refer to 400 of FIG. 6) covering the lower panel layer. In embodiments, the lower panel layer includes an anode Anode, a pixel defining layer (refer to 380 of FIG. 6), a light emitting layer (refer to EML of FIG. 6), a spacer (refer to 385 of FIG. 6), a function layer (refer to FL of FIG. 6), a cathode (refer to Cathode of FIG. 6) from a substrate (refer to 110 of FIG. 6) to the encapsulation layer, and includes an insulation layer (e.g., an electrically insulating layer), a semiconductor layer, and a conductive layer (e.g., an electrically conductive layer) between the substrate and the anode. In embodiments, the upper panel layer is a portion above the encapsulation layer, and includes a sensing insulation layer that can detect a touch (refer to 501, 510, and 511 of FIG. 6) and a plurality of sensing electrodes (refer to 540 and 541 of FIG. 6), and may include a light blocking layer (refer to 220 of FIG. 6), a color filter (refer to 230 of FIG. 6), and a planarization layer (refer to 550 of FIG. 6).

The first component area EA1 may be formed only of a transparent layer to allow light to pass through, and a conductive layer (e.g., an electrically conductive layer) or a semiconductor layer may not be provided to allow light to pass through, and may have an optical sensor region in the lower panel layer, and an opening (hereinafter, also referred to as an additional opening) may be provided in the pixel defining layer, the light blocking layer, and the color filter layer of the upper panel layer at a position corresponding to the first component area EA1 to have a structure that does not block light (e.g., substantially does not block transmission of light). In embodiments, even if the optical sensor region is provided in the lower panel layer, it may be the display area DA rather than the first component area EA1 if there is no corresponding opening in the upper panel layer. One first component area EA1 may include a plurality of adjacent optical sensor regions, and in this embodiment, a pixel adjacent to the optical sensor region may be included in the first component area EA1. In embodiments, when the first optical element ES1 corresponding to the first component area EA1 uses infrared light rather than visible light, the first component area EA1 may overlap the light blocking layer 220 that blocks visible light (or reduces transmission of visible light).

The second component area EA2 may include a second component pixel and a light transmitting region, and a space between adjacent second component pixels may be the light transmitting region.

Although it is not illustrated in FIG. 5, a peripheral area may further be provided at an outer side of the display area DA. FIG. 5 illustrates a display panel for a mobile phone, but the present embodiment may be applied to any suitable display panel on which an optical element can be on a rear surface the display panel, and it may also be a flexible display device. In embodiments of a foldable display device among flexible display devices, the positions of the second component area EA2 and the first component area EA1 may be formed at positions different from those in FIG. 5.

Hereinafter, a structure of a light emitting display panel DP according to an embodiment will be described.

FIG. 6 is a schematic cross-sectional view of a display panel according to an embodiment.

A light emitting display panel DP according to an embodiment may display an image by providing a light emitting diode on a substrate 110, sense a touch by including a plurality of sensing electrodes 540 and 541, and includes a light blocking layer 220 and a color filters 230R, 230G, and 230B such that the light emitted from the light emitting diode also has the color characteristics of the color filters 230R, 230G, and 230B.

In embodiments, a polarizing plate is not formed on the front surface of the light emitting display panel DP according to an embodiment, and instead, a pixel defining layer 380 is provided with a black color organic material, while the light blocking layer 220 and the color filter 230 are on an upper portion such that even if external light is incident on the inside, it is not reflected by an anode Anode and/or the like and transmitted to the user. In embodiments, because the polarizing plate is not formed, the luminance does not decrease as the light emitted from the light emitting layer is partially absorbed by the polarizing plate, and thus a light emitting display device having a maximum luminance value of 2500 Nit or more can be provided.

The light emitting display panel DP according to an embodiment will be described in more detail as follows.

The substrate 110 may include a rigid material such as glass that does not bend, or a flexible material that can be bent such as plastic (e.g., polymer) and/or polyimide.

A plurality of thin film transistors are on the substrate 110, but they are omitted in FIG. 6, and only an organic layer 180 covering the thin film transistors is shown. One pixel is provided with a pixel circuit portion, which includes a light emitting diode and a plurality of transistors and capacitors that transmit a light emitting current to the light emitting diode. In FIG. 6, a pixel circuit portion is not illustrated, and a structure of the pixel circuit portion may suitably vary depending on embodiments. FIG. 6 illustrates from an organic layer 180 covering the pixel circuit portion.

A light emitting diode including the anode Anode, the light emitting layer EML, and a cathode Cathode is on the organic layer 180.

The anode Anode may be formed of a single layer including a transparent conductive oxide layer and a metal material, or a plurality of layers including a transparent conductive oxide layer and/or a metal material. The transparent conductive oxide layer may include an indium tin oxide (ITO), a poly-ITO, an indium zinc oxide (IZO), an indium gallium zinc oxide (IGZO), an indium tin zinc oxide (ITZO), and/or the like, and the metal material may include silver (Ag), molybdenum (Mo), copper (Cu), gold (Au), aluminum (Al), and/or the like.

The light emitting layer EML may be formed of an organic light emitting material, and adjacent light emitting layers EML may display different colors. Depending on embodiments, the respective light emitting layers EML may display the same color by color filters 230R, 230G, and 230B provided above. Depending on embodiments, the light emitting layer EML may have a structure (also referred to as a tandem structure) in which a plurality of light emitting layers are stacked.

The pixel defining layer 380 is on the organic layer 180 and the anode Anode, and an opening OP (hereinafter, also referred to as a first opening) is provided in the pixel defining layer 380. The opening partially overlaps the anode Anode, and the light emitting layer EML is on a portion of the anode Anode, exposed by the opening OP. The light emitting layer EML may be provided only in the opening OP of the pixel defining layer 380, and is separated from the adjacent light emitting layer EML by the pixel defining layer 380.

The pixel defining layer 380 may be formed of an organic material having a negative type black color (e.g., a negative kind of black color). The organic material having a black color may include a light blocking material, and the light blocking material may include carbon black, carbon nanotubes, a resin and/or paste containing black dye, metal particles such as nickel, aluminum, molybdenum, and/or an alloy thereof, and/or metal oxide particles (e.g., chromium nitride). The pixel defining layer 380 has a black color, including a light blocking material, and may have a characteristic in which light is not reflected and is absorbed/blocked. Because the negative type (or kind) of organic material is used, it may have a characteristic of removing a part covered by a mask.

The spacer 385 is formed on the pixel defining layer 380. The spacer 385 includes a first portion 385-1 provided in a tall and narrow area and a second portion 385-2 provided in a low and wide area. In FIG. 6, the first portion 385-1 and the second portion 385-2 are separated by the dotted line in the spacer 385. In embodiments, the first portion 385-1 may serve to secure rigidity against pressing pressure by reinforcing scratch strength. The second portion 385-2 may serve as a contact assistant between the pixel defining layer 380 and an upper function layer FL. The first portion 385-1 and the second portion 385-2 are formed of the same material, which may be formed of a positive type (or kind of) photosensitivity organic material, for example, photosensitivity poly imide (PSPI) may be used. Because it has a positive characteristic, a part not covered by the mask can be removed. The spacer 385 is transparent, and thus light may pass through and/or may be reflected.

The pixel defining layer 380 may be formed as a negative type (or kind), and the spacer 385 may be formed as a positive type (or kind), and depending on embodiments, they may include the same type (or kind) of material.

A part of an upper surface of the pixel defining layer 380 is covered by the spacer 385, and an edge of the second portion 385-2 is separated from an edge of the pixel defining layer 380 such that a part of the pixel defining layer 380 is not covered by the spacer 385. The second portion 385-2 may cover an upper surface of the pixel defining layer 380 where the first portion 385-1 is not provided, thereby strengthening the adhesion characteristic between the pixel defining layer 380 and the function layer FL. In the present embodiment, the spacer 385 is provided only in a region that overlaps the light blocking layer 220 on a plane, which will be further described herein, and thus the spacer 385 may not be visible behind the light blocking layer 220 when viewed from the front of the display panel DP.

The function layer FL is on the spacer 385 and the exposed pixel defining layer 380, and the function layer FL may be provided in the front surface of the light emitting display panel DP or may be provided in the entire light emitting display panel DP, excluding a part, for example, a light transmitting of the second component area EA2. The function layer FL may include an electron injection layer, an electron transport layer, a hole transport layer, and a hole injection layer, and the function layer FL may be provided above and/or below the light emitting layer EML. For example, the hole injection layer HIL, the hole transport layer, the light emitting layer EML, the electron transport layer, the electron injection layer EIL, and the cathode Cathode are sequentially on the anode Anode such that the hole injection layer and the hole transport layer of the function layer FL may be provided below the light emitting layer EML and the electron transport layer and the electron injection layer EIL may be provided above the light emitting layer EML.

The spacer 385 may increase scratch strength of the light emitting display panel DP to reduce a defect occurrence rate due to pressing pressure, and depending on embodiments, and may increase the adhesive strength with the function layer FL provided above the spacer 385 to prevent or reduce injection of moisture and/or air from the outside. In embodiments, high adhesive strength has a merit of being able to eliminate a problem of deterioration of adhesive strength between layers when the light emitting display panel DP has flexible characteristics and is folded and/or unfolded.

The cathode Cathode may be formed of a transmissive electrode or a reflecting electrode. Depending on embodiments, the cathode may be a transparent or semi-transparent electrode and may be formed of a metal thin film having a small work function including lithium (Li), calcium (Ca), fluorinated lithium/calcium (LiF/Ca), fluorinated lithium/aluminum (LiF/Al), aluminum (Al), silver (Ag), magnesium (Mg), and a compound thereof. In embodiments, a transparent conductive oxide (TCO) layer such as indium tin oxide (ITO), an indium zinc oxide (IZO), zinc oxide (ZnO), and/or indium oxide (In₂O₃) may be further on the metal thin film. The cathode may be formed integrally across the entire surface of the light emitting display panel DP.

The encapsulation layer 400 is on the cathode Cathode. The encapsulation layer 400 includes at least one inorganic layer and at least one organic layer, and in FIG. 6, the encapsulation layer 400 has a triple-layer structure including a first inorganic encapsulation layer 401, an organic encapsulation layer 402, and a second inorganic encapsulation layer 403. The encapsulation layer 400 may be to protect the light emitting layer EML formed of an organic material from moisture and/or oxygen that may inflow from the outside. Depending on embodiments, the encapsulation layer 400 may include a structure in which inorganic layers and organic layers are sequentially more stacked.

On the encapsulation layer 400, sensing insulation layers 501, 510, and 511 and a plurality of sensing electrodes 540 and 541 are provided to sense a touch. In the embodiment of FIG. 6, a touch is detected in a capacitive type (or kind) using two sensing electrodes 540 and 541, but depending on embodiments, a touch may also be detected in a cell-cap type (or kind) using only one sensing electrode. The plurality of sensing electrodes 540 and 541 may be insulated (e.g., electrically insulated) from each other, while providing a second sensing insulation layer 510 therebetween, and a lower sensing electrode 541 is on a first sensing insulation layer 501, an upper sensing electrode 540 is on the second sensing insulation layer 510, and the upper sensing electrode 540 is covered by a third sensing insulation layer 511. The plurality of sensing electrodes 540 and 541 may be electrically connected with each other through an opening provided in the second sensing insulation layer 510. In embodiments, the sensing electrodes 540 and 541 may include a metal such as aluminum (Al), copper (Cu), silver (Ag), gold (Au), molybdenum (Mo), titanium (Ti), and/or tantalum (Ta), and/or a metal alloy thereof and may be formed of a single layer or a plurality of layers.

The light blocking layer 220 and the color filters 230R, 230G, and 230B are on the third sensing insulation layer 511.

The light blocking layer 220 may overlap the sensing electrodes 540 and 541 on a plane, and may not overlap the anode Anode on a plane. This is to prevent the anode Anode and the light emitting layer EML, which can display an image, from being covered by the light blocking layer 220 and the sensing electrodes 540 and 541.

Referring to FIG. 6, the light blocking layer 220 is provided only in a region that overlaps the pixel defining layer 380 on a plane, and one side of the light blocking layer 220 is provided inward from the corresponding side of the pixel defining layer 380.

The light blocking layer has a second opening OPBM (hereinafter also referred to as second opening), and the area of the second opening OPBM of the light blocking layer 220 is larger than the opening OP of the pixel defining layer 380, and the opening OP of the pixel defining layer 380 may be provided in the second opening OPBM of the light blocking layer 220 on a plane.

In embodiments, one side of the spacer 385 is provided inwardly by a set or certain distance g1 from the corresponding side of the pixel defining layer 380, and the spacer 385 is also provided inwardly with respect to one side of the light blocking layer 220. As a result, when viewed from the front of the display panel DP, the spacer 385 may not be visible due to the light blocking layer 220.

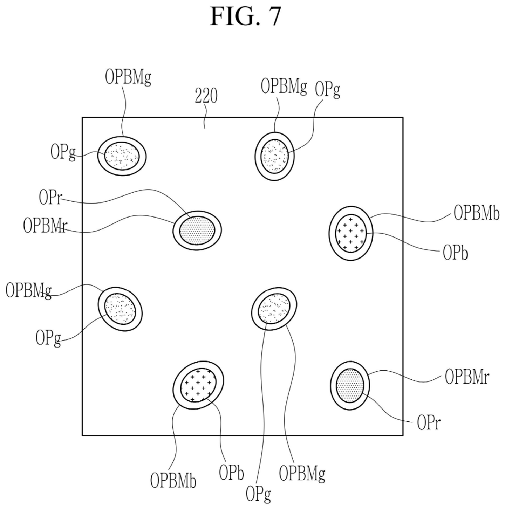

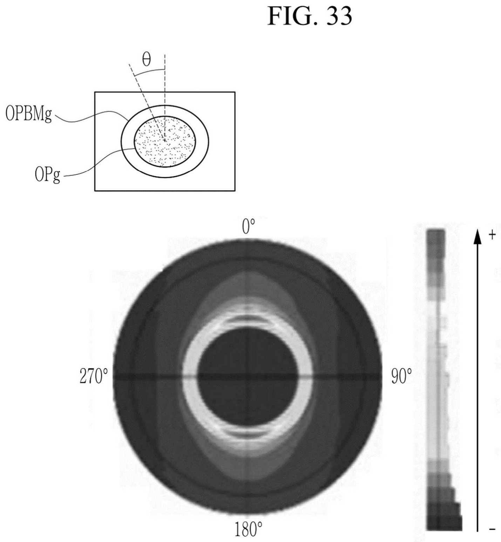

When external light is incident, it may pass through the second opening OPBM of the light blocking layer 220 and then be reflected from a side wall of the opening OP of the pixel defining layer 380. The side wall of the opening OP of pixel defining layer 380 is curved, and thus color separation occurs depending on the reflected position, and the colors of the reflected light may appear as various suitable colors like a rainbow. In embodiments, when at least one selected from the openings OP and OPBM is formed in an elliptical shape (e.g., a generally elliptical shape) and has directionality, as shown in FIG. 33, the degree of external light reflection may suitably vary depending on the angle, and thus periodic stains may be visible depending on the angle. Because such color-separated reflection light or stains may be easily noticeable to the user and cause deterioration of the display quality, the minimum number of unit pixels included in an repeating unit pixel repeatedly provided in the display area may be reduced to, for example, a 2x2 array, or a difference in the reflectance of external light according to the angle may be formed to be similar within a set or certain range such that the difference in reflectance of external light is not recognized by the user. In embodiments, the second opening OPBM of the light blocking layer 220 and the opening OP of the pixel defining layer 380 are each provided in an elliptical shape (e.g., a generally elliptical shape), and the direction or eccentricity of the ellipse is provided in various suitable ways to reduce color separation or to allow white reflected light to be recognized. This will be described in more detail with reference to FIG. 7.

The color filters 230R, 230G, and 230B are on the sensing insulation layers 501, 510, and 511 and the light blocking layer 220. The color filters 230R, 230G, and 230B includes a red color filter 230R that transmits red light, a green color filter 230G that transmits green light, and a blue color filter 230B that transmits blue light. Each of the color filters 230R, 230G, and 230B may overlap the anode Anode of the light emitting diode on a plane, and one of the color filters 230R, 230G, and 230B may be filled in the second opening OPBM of the light blocking layer 220. A part of the color filters 230R, 230G, and 230B may be also be on the upper surface of the light blocking layer 220. Light emitted from the light emitting layer EML may be emitted while changing to the corresponding color as it passes through the color filter, and therefore all light emitted from the light emitting layer EML may have the same color. However, the light emitting layer EML may display different colors of light and enhance the displayed color by allowing the light to pass through a color filter of the same color.

The light blocking layer 220 may be between each of the color filters 230R, 230G, and 230B. Depending on embodiments, the color filters 230R, 230G, and 230B may be replaced with a color conversion layer or may further include a color conversion layer. The color conversion layer may include quantum dots.

A planarization layer 550 that covers the color filters 230R, 230G, and 230B is on the color filters 230R, 230G, and 230B. The planarization layer 550 planarizes the upper surface of the light emitting display panel and may be a transparent organic insulator (e.g., a transparent organic electrical insulator) including one or more materials selected from the group consisting of polyimide, polyamide, acryl resin, benzocyclobutene, and phenol resin.

Depending on embodiments, a low-refractive layer and an additional planarization layer may be on the planarization layer 550 to improve frontal visibility and light output efficiency of the display panel. Light may be refracted and emitted toward the front by the additional planarization layer having low refractive index and high refractive index characteristics. In this embodiment, depending on embodiments, the planarization layer 550 may be omitted and the low-refractive layer and the additional planarization layer may be directly on the color filter 230.

In the present embodiment, a polarizing plate may not be included above the planarization layer 550. For example, the polarizing plate may serve to prevent or reduce display quality deterioration when external light is incident and visible to a user while being reflected from the anode Anode or the side wall of the opening OP of the pixel defining layer 380. However, the polarizing plate has a drawback of consuming more electric power to display a set or certain luminance because it not only reduces the reflection of external light, but also reduces the light emitted from the light emitting layer EML. To reduce power consumption, the light emitting display device according to the present embodiment may not include a polarizing plate. In embodiments, the light emitting display device of the present embodiment does not include a polarizing plate, and therefore light emitted from the light emitting layer is partially observed by the polarizing plate such that luminance is not decreased, thereby providing a light emitting display device having the maximum luminance value of 2500 Nit or more.

In the present embodiment, a structure that covers a side surface of the anode Anode with the pixel defining layer 380 to reduce the amount of reflection from the anode Anode is included, and the light blocking layer 220 is also provided to reduce the amount of light entering, thereby preventing or reducing deterioration of display quality due to reflection. Therefore, there is no need to form a polarizing plate separately on the front side of the light emitting display panel DP.

The plurality of pixels are provided in the display area DA of the light emitting display device and thus an image is displayed, and one pixel may include at least two of sub-pixels of a red R, a green G, and a blue B. The display area DA includes a minimum unit pixel including at least one of sub-pixels of the red R, the green G, and the blue B, and the minimum unit pixel may have an elliptical shape (e.g., a generally elliptical shape) of openings OP and OPBM that is different from that of an adjacent minimum unit pixel in terms of eccentricity and/or major axis direction. In embodiments, the minimum unit pixel may be provided within a square or equivalent area of the display area DA. Such a of minimum unit pixel is included in plurality and thus an repeating unit pixel is provided, and the repeating unit pixel may be formed while being repeated within the entire region of the display area DA. The repeating unit pixel may have an elliptical shape (e.g., a generally elliptical shape) of the openings OP and OPBM corresponding to an adjacent repeating unit pixel with the same eccentricity and the same major axis direction. The repeating unit pixel may also be provided within a square or equivalent area in the display area DA, but has an area larger than the area where the minimum unit pixel is provided.

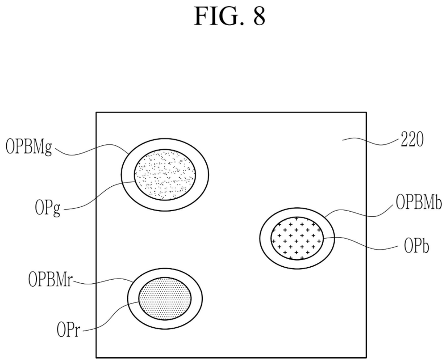

Hereinafter, two types (or kinds) of structures of the minimum unit pixel provided in the display area DA will be described with reference to FIG. 7 and FIG. 8. The embodiment of the minimum unit pixel shown in FIG. 7 and FIG. 8 is a minimum unit pixel used in embodiments described throughout the present specification, and a minimum unit pixel other than the minimum unit pixel shown in FIG. 7 and FIG. 8 may be provided in the display area DA of the light emitting display device. The minimum unit pixel includes at least one subpixel of the red R, the green G, and the blue B, and may be provided at various suitable angles with an elliptical shape (e.g., a generally elliptical shape) along various suitable major axis direction angles and eccentricities.

FIG. 7 and FIG. 8 are top plan views of a minimum unit pixel provided in a display panel according to an embodiment.

Referring to FIG. 7 and FIG. 8, a second opening of the light blocking layer 220 and a first opening of the pixel defining layer included in the light emitting display panel DP are respectively provided in the shape of an ellipse (e.g., generally an ellipse).

First, a minimum unit pixel according to the embodiment of FIG. 7 will be further described.

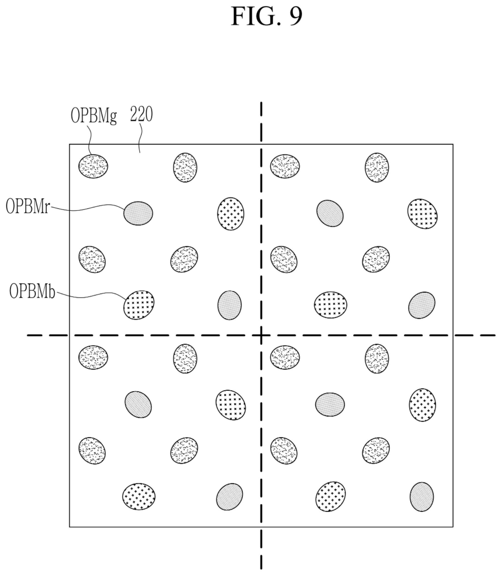

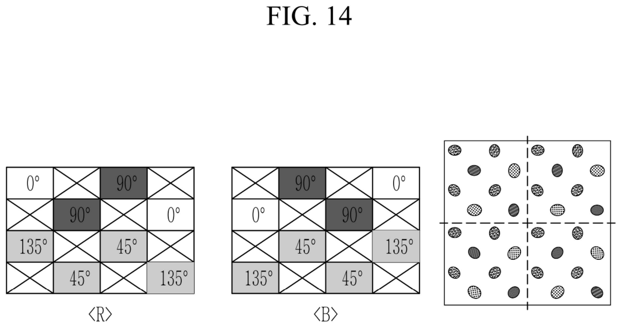

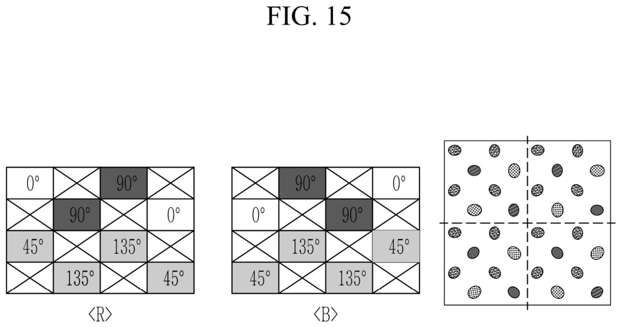

The minimum unit pixel of FIG. 7 is also referred to as a first minimum unit pixel, and may be a minimum unit pixel to form a first repeating unit pixel. The first repeating unit pixel may also called a diamond array and is illustrated in FIG. 9, and FIG. 13 to FIG. 17. The first minimum unit pixel may include, as shown in FIG. 7, four green G subpixels, two red R subpixels, and two blue B subpixels. FIG. 7 illustrates a planar shape of each subpixel when viewed from the front of the light emitting display panel DP. Most of the region is blocked by the light blocking layer 220, and first openings OPr, OPg, and OPb of the pixel defining layer (refer to 380 of FIG. 6) are illustrated through a part that is not blocked by second openings OPBMr, OPBMg, and OPBMb of the light blocking layer 220. The pixel defining layer is provided in a region between the second openings OPBMr, OPBMg, and OPBMb of the light blocking layer 220 and the first openings OPr, OPg, and OPb of the pixel defining layer (refer to 380 in FIG. 6), and the light emitting layer (refer to EML of FIG. 6) is provided in the first openings OPr, OPg, and OPb of the pixel defining layer. Within the first openings OPr, OPg, and OPb of the pixel defining layer, the light emitting layer is distinguished by diagonal lines having different colors.

In FIG. 7, the green G subpixel corresponds to a second opening OPBMg of the light blocking layer 220 of green color and a first opening OPg of a pixel defining layer of green color, and a portion where light is actually emitted may be a light emitting layer provided in the first opening OPg of the green pixel defining layer. In embodiments, the red R subpixel corresponds to a second opening OPBMr of a light blocking layer 220 of red color and a first opening OPr of a pixel defining layer of red color, and the blue B subpixel corresponds to a second opening OPBMb of a light blocking layer 220 of blue color and a first opening OPb of a pixel defining layer of blue color.

Referring to the first minimum unit pixel according to the embodiment of FIG. 7, four green G subpixels are included, and a square (hereinafter, also called a first square) may be formed by connecting the four green G subpixels in horizontal and vertical straight lines at regular intervals. One red R subpixel is provided in a square formed of four green G subpixels. However, depending on embodiments, one blue B subpixel may be provided. In embodiments, there are two red R subpixels and two blue B subpixels, each provided in a diagonal direction relative to each other. A square (hereinafter, also called a second square) may be formed by connecting two red R subpixels and two blue B subpixels in horizontal and vertical straight lines at regular intervals.

The second openings OPBMr, OPBMg, and OPBMb of the light blocking layer 220 included in the first minimum unit pixel and the first openings OPr, OPg, and OPb of the pixel defining layer may be provided with various suitable eccentricities and major axis directions, respectively. In the first minimum unit pixel of the embodiment of FIG. 7, the first openings OPr, OPg, and OPb of the same color have the same eccentricity, and the second openings OPBMr, OPBMg, and OPBMb of the same color have the same eccentricity, but the angles of their major axis directions may be provided differently. In the first minimum unit pixel of the embodiment of FIG. 7, the angle in the major axis direction is provided as one of 0 degrees, 45 degrees, 90 degrees, and 135 degrees. Depending on embodiments, there may be an angular difference of 45*n degrees (where n is a natural number greater than or equal to 1 and less than or equal to 8) between the major axes of adjacent same-colored ellipses in the minimum unit pixel. In embodiments, depending on embodiments, the number of long-axis directions of adjacent same-colored ellipse in the minimum unit pixel and/or repeating unit pixel may be four or more, and in this embodiment, the interval between the long-axis directions may have an angle that is not constant, such as 30 degrees or more and 60 degrees or less.

The first minimum unit pixel of the embodiment of FIG. 7 may be combined with an adjacent first minimum unit pixel formed by changing the eccentricity of the ellipse and/or the angle of the major axis direction in FIG. 9 and the like to form one first repeating unit pixel. The first repeating unit pixel according to an example embodiment will be further described with respect to FIG. 9 and the like.

A minimum unit pixel according to the embodiment of FIG. 8 will be further described.

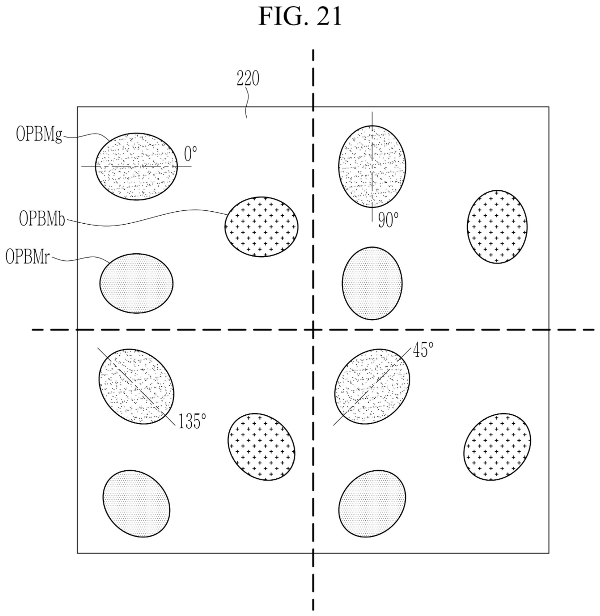

The minimum unit pixel of FIG. 8 will be hereinafter called a second minimum unit pixel, and may be a minimum unit pixel to provide a second repeating unit pixel. The second repeating unit pixel may be provided in an S-stripe array and is illustrated in FIG. 21, FIG. 23, FIG. 25, FIG. 29, and FIG. 37. The second minimum unit pixel may include, as shown in FIG. 8, one green G subpixel, one red R subpixel, and one blue B subpixel. FIG. 8 illustrates a planar shape of each subpixel when viewed from the front of the light emitting display panel DP. Most of the region is blocked by the light blocking layer 220, and the first openings OPr, OPg, and OPb of the pixel defining layer (refer to 380 of FIG. 6) is illustrated through a part that is not blocked by the second openings OPBMr, OPBMg, and OPBMb of the light blocking layer 220. The pixel defining layer is provided in a region between the second openings OPBMr, OPBMg, and OPBMb of the light blocking layer 220 and the first openings OPr, OPg, and OPb of the pixel defining layer (refer to 380 in FIG. 6), and the light emitting layer (refer to EML of FIG. 6) is provided in the first openings OPr, OPg, and OPb of the pixel defining layer. Within the first openings OPr, OPg, and OPb of the pixel defining layer, the light emitting layer is distinguished by diagonal lines having different colors.

In FIG. 8, the green G subpixel corresponds to a second opening OPBMg of the light blocking layer 220 of green color and a first opening OPg of a pixel defining layer of green color, and a portion where light is actually emitted may be a light emitting layer provided in the first opening OPg of the green pixel defining layer. In embodiments, the red R subpixel corresponds to a second opening OPBMr of a light blocking layer 220 of red color and a first opening OPr of a pixel defining layer of red color, and the blue B subpixel corresponds to a second opening OPBMb of a light blocking layer 220 of blue color and a first opening OPb of a pixel defining layer of blue color.

Referring to the second minimum unit pixel according to the embodiment of FIG. 8, each of the green G subpixel, the red R subpixel, and the blue B subpixel is included, and a triangle shape may be formed by connecting them with a straight line (e.g., with three straight lines).

The second openings OPBMr, OPBMg, and OPBMb of the light blocking layer 220 included in the second minimum unit pixel and the first openings OPr, OPg, and OPb of the pixel defining layer may be provided with various suitable eccentricities and major axis directions, respectively. In the embodiment of FIG. 8, the major axis direction angle of the second minimum unit pixel is provided as one of 0 degrees, 45 degrees, 90 degrees, and 135 degrees. Depending on embodiments, there may be an angular difference of 45*n degrees (where n is a natural number greater than or equal to 1 and less than or equal to 8) between the major axes of adjacent same-colored ellipses in the minimum unit pixel. In embodiments, depending on embodiments, the number of long-axis directions of adjacent same-colored ellipse in the minimum unit pixel and/or repeating unit pixel may be four or more, and in this embodiment, the interval between the long-axis directions may have an angle that is not constant, such as 30 degrees or more and 60 degrees or less.

The second minimum unit pixel of the embodiment of FIG. 8 may be combined with an adjacent first minimum unit pixel formed by changing the eccentricity of the ellipse and/or the angle of the major axis direction in FIG. 219 and the like to form one second repeating unit pixel. The second repeating unit pixel according to an example embodiment will be further described with respect to FIG. 21 and the like.

Hereinabove, a structure of two types (or kinds) of minimum unit pixels was described with reference to FIG. 7 and FIG. 8. The minimum unit pixels according to the embodiments of FIG. 7 and FIG. 8 are distinguished by a green pixel as a reference, and depending on embodiments, they may be distinguished by a red pixel or blue pixel as a reference. In this embodiment, the pixel provided at the upper left may be a pixel of a different color than the green pixel.

Hereinafter, an repeating unit pixel according to each embodiment will be described based on the minimum unit pixel. First, a structure of a first repeating unit pixel including a first minimum unit pixel will be described with reference to FIG. 9 to FIG. 20, and then a structure of a second repeating unit pixel including a second minimum unit pixel will be described with reference to FIG. 21 to FIG. 28.

FIG. 9 to FIG. 17 show an repeating unit pixel provided in a display panel according to an embodiment.

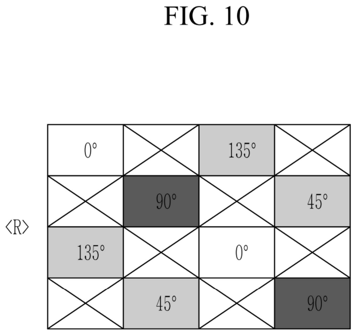

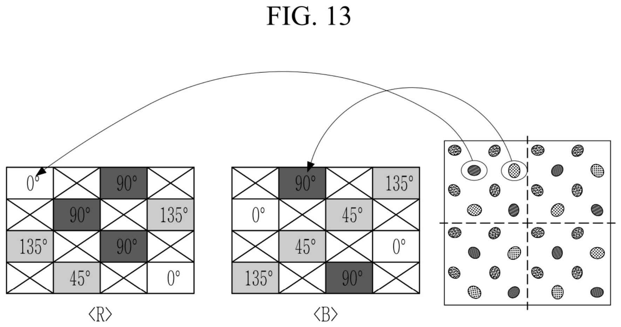

FIG. 9 shows a planar structure of a first repeating unit pixel, FIG. 10 to FIG. 12 show an angle of an elliptical major axis direction of each subpixel included in the first repeating unit pixel in a table, and FIG. 13 to FIG. 17 illustrate a table showing the angle along the elliptical major axis direction and the corresponding planar structure of the first repeating unit pixel. In embodiments, the first repeating unit pixel includes or consists of the first minimum unit pixels provided in a 2x2 array.

First, a first repeating unit pixel according to the embodiment of FIG. 9 will be further described.

Contrary to that shown in FIG. 7, FIG. 9 does not illustrate the first openings OPr, OPg, and OPb of the pixel defining layer, and only illustrates the second openings OPBMr, OPBMg, and OPBMb of the light blocking layer 220. In embodiments, the first openings OPr, OPg, and OPb provided in the second openings OPBMr, OPBMg, and OPBMb may have eccentricity corresponding to the eccentricity of the second openings OPBMr, OPBMg, and OPBMb and may have an elliptical major axis direction that is the same as or similar to the elliptical major axis direction of the second openings OPBMr, OPBMg, and OPBMb. Contrary to that shown in FIG. 7, in FIG. 9, the second openings OPBMr, OPBMg, and OPBMb of the light blocking layer 220 is filled with diagonal lines, and each is distinguished by diagonal lines different in each color.

In the embodiment of FIG. 9, the first minimum unit pixel that constitutes the first repeating unit pixel is divided by a dotted line, and it may be confirmed that the first minimum unit pixel is provided in a 2x2 array. In the embodiment of FIG. 9, the first minimum unit pixel is distinguished by a dotted line based on a green pixel as a reference, and depending on embodiments, the first minimum unit pixel may be distinguished using a red pixel or a blue pixel as a reference.

The four first minimum unit pixels included in the first repeating unit pixel may have different major axis direction angles and/or eccentricities, and the first repeating unit pixel provided in the display area DA may have the same major axis direction angle and eccentricity as the adjacent first repeating unit pixels.

Second openings OPBMr, OPBMg, and OPBMb of the same color included in the first repeating unit pixel of the embodiment of FIG. 9 have the same eccentricity. In embodiments, a first opening of a pixel defining layer of the same color may also have the same eccentricity. In embodiments, the angle of the major axis direction of the second openings OPBMr, OPBMg, and OPBMb included in the first repeating unit pixel of the embodiment of FIG. 9 may be one of 0 degrees, 45 degrees, 90 degrees, and 135 degrees, and the angle of the major axis direction is organized in the tables of FIG. 10 to FIG. 12.

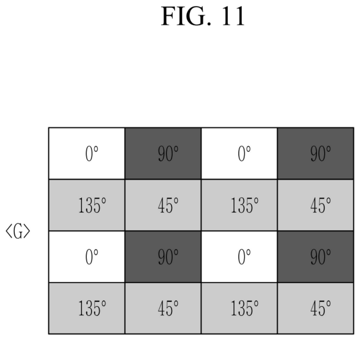

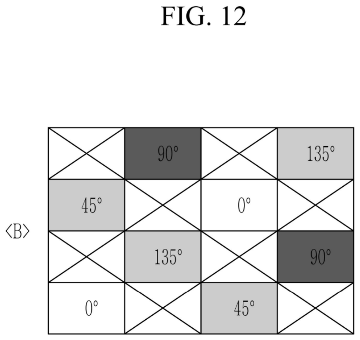

FIG. 10 shows a major axis direction angle of the red R subpixel, FIG. 11 shows a major axis direction angle of the green G subpixel, and FIG. 12 shows a major axis direction angle of the blue B subpixel.

In FIG. 10, there are cells with the major axis direction angle described and cells marked with an X, and the cells marked with an X indicate a portion where the blue B subpixel of FIG. 12 is provided. In FIG. 12, there are cells with the major axis direction angle described and cells marked with an X, and the cells marked with an X indicate a portion where the red R subpixel of FIG. 10 is provided. For example, when FIG. 10 and FIG. 12 are combined, one table is completed and the overall major axis direction angle is displayed, indicating that the red R subpixel or blue B subpixel are provided at the corresponding position with the written major axis direction angle. On the contrary, in FIG. 11, the major axis direction angle is described for every cell, and the major axis direction angle of the green G subpixel at every position is described.

Referring to the second opening OPBMr of the light blocking layer 220 corresponding to the red R subpixel of FIG. 9 and FIG. 10, the angle of the major axis direction of the second opening OPBMr of light blocking layer 220 can be clearly confirmed. For example, the second opening OPBMr of the light blocking layer 220 corresponding to the red R subpixel in FIG. 9 is included in total of 8, and the major axis direction angle corresponding to these positions is described in the table of FIG. 10. For example, 0 degree provided in the first row and the first column in the table FIG. 10 represents the angle in the major axis direction of the second opening OPBMr provided at the upper leftmost side among the second openings OPBMr of the light blocking layer 220 corresponding to the red R subpixel in FIG. 9. In embodiments, the 45 degree provided in the second row and the first column in the table of FIG. 12 represents the angle of the major axis direction of the second opening OPBMr on the upper side among the two second openings OPBMr on the most left among the second openings OPBMb of the light blocking layer 220 corresponding to the blue B subpixel in FIG. 9.

Referring to FIG. 11, it can be confirmed that the second openings OPBMg of the four light blocking layers 220 corresponding to the green G subpixel in the first repeating unit pixel according to the embodiment of FIG. 9 are arranged with the same major axis direction angle at each corresponding position in each of the four minimum unit pixels. On the contrary, referring to FIG. 10 and FIG. 12, the second openings OPBMr and OPBMb of the light blocking layer 220 corresponding to the red R and blue B subpixels according to the embodiment of FIG. 9 are with different major axis direction angles at the corresponding positions for each adjacent minimum unit pixel. However, depending on embodiments, the major axis direction angles between the first repeating unit pixels may differ by one or more, and the eccentricities may also be different. In the first repeating unit pixel, the major axis direction angle of the second openings OPBMr and OPBMb of the light blocking layer 220 corresponding to the red R and blue B subpixels may have a greater influence on the reflection characteristic of external light than the second openings OPBMg of the four light blocking layers 220 corresponding to the green G subpixels included in the largest number.

In FIG. 10 to FIG. 12, the cells are filled with the major axis direction angle of 0 degrees as bright, the major axis direction angle of 90 degrees as darkest, and the major axis direction angles of 45 degrees and 135 degrees as intermediate dark. This is because when observed from below, 0 degrees is the brightest, 90 degrees is the darkest, and 45 degrees or 135 degrees are intermediate brightness. However, the degree of reflection of external light may change depending on the user's viewing position. The table below shows the same corresponding major axis direction angles.

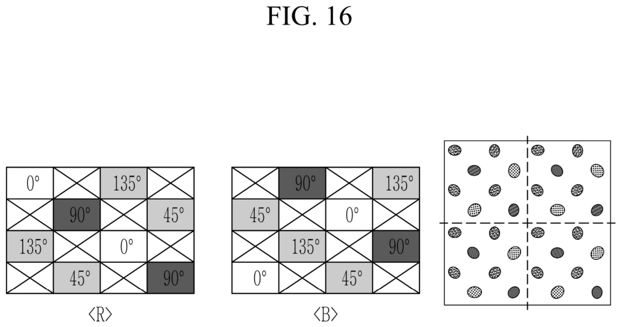

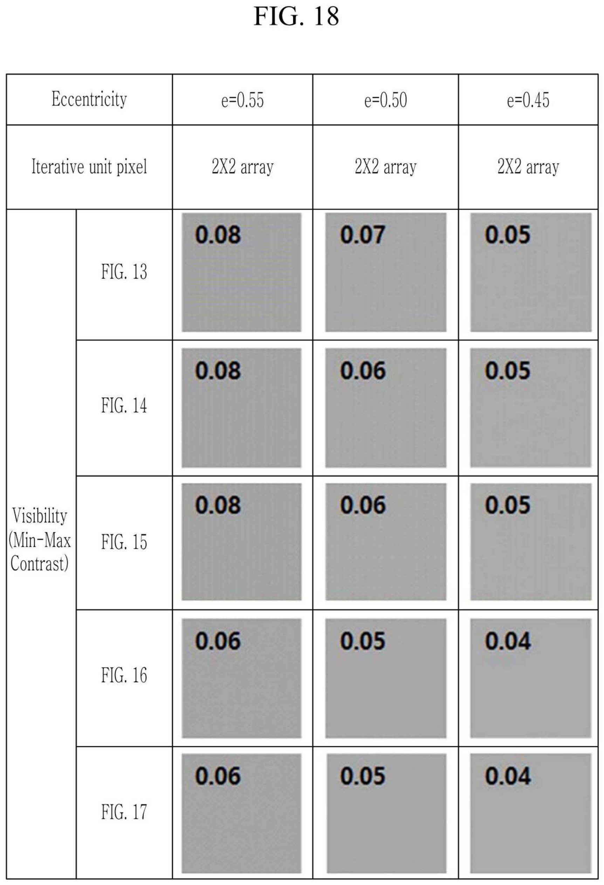

FIG. 13 to FIG. 17 illustrate various suitable variations of embodiments. FIG. 13 to FIG. 17 are for comparing the effects of FIG. 18, and FIG. 16 may be the same embodiment as the embodiment of FIG. 9.

FIG. 13 to FIG. 17 illustrate a major axis direction angle of the second openings OPBMr and OPBMb of the light blocking layer 220 corresponding to the red R and blue B subpixels and a planar structure of the corresponding first repeating unit pixel. That is, in FIG. 13 to FIG. 17, the major axis direction angle of the second openings OPBMg of the four light blocking layers 220 corresponding to the green G subpixel are not described. In embodiments, the angle of the major axis direction of the second openings OPBMg of the four light blocking layers 220 corresponding to the green G subpixel may be provided the same as or differently from FIG. 11. However, because the major axis direction angle of the second openings OPBMr and OPBMb of the light blocking layer 220 corresponding to the red R and blue B subpixels may have a greater influence on the reflection characteristic of external light than the major axis direction angle of the second openings OPBMg of the four light blocking layers 220 corresponding to the green G subpixels, which are included in the largest number in the first repeating unit pixel, the major axis direction angle of the second openings OPBMr and OPBMb of light blocking layer 220 corresponding to the red R and blue B subpixels will be mainly described.

In FIG. 13, the second openings OPBMr and OPBMb of the light blocking layer 220 are connected to the corresponding major axis direction angles described in the table through the arrows. This is an example, and the angles along the major axis direction listed in the table correspond to the second openings OPBMr and OPBMb of light blocking layer 220 with the same relationship.

Hereinafter, the reflection characteristics of external light according to the change in eccentricity for the various embodiments of first repeating unit pixels shown in FIG. 13 to FIG. 17 will be described with reference to FIG. 18.

FIG. 18 summarizes the characteristics of reflected light for some embodiments.

The numbers described in FIG. 18 are visibility values, where the visibility value is a difference value (Min-Max Contrast) between the maximum value and the minimum value of the reflected light luminance according to the position in the first repeating unit pixel, and the larger the difference, the more likely it is that the reflection of external light will be perceived as a stain by the user.

In FIG. 18, the visibility of external light is simulated by changing an eccentricity value e of the second opening of the light blocking layer 220 of green G to 0.55, 0.50, and 0.45 in the first repeating unit pixel where the first minimum unit pixels are arranged in a 2x2 array like in FIG. 11 to FIG. 15, and the visibility value according to it is described.

Referring to FIG. 18, it can be seen that as the eccentricity value e decreases, the visibility value also decreases. Therefore, the smaller the eccentricity value e of the elliptical shape of the opening included in the first repeating unit pixel, the less external light may be recognized. An eccentricity value e of the second opening of the light blocking layer 220 of green G may have a value greater than or equal to 0.40 and less than or equal to 0.55, and depending on embodiments, the eccentricity value e may be smaller than 0.40. In embodiments, the eccentricity value e of the second opening of the light blocking layer corresponding to the red R and blue B subpixels may also have a value similar to that of green G.

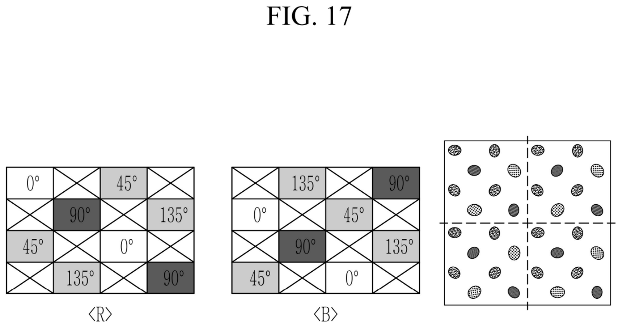

In embodiments of having the same eccentricity value e in FIG. 18, arranging the major axis direction of the second opening as in FIG. 16 and FIG. 17 may prevent or reduce recognition of the reflection stain of external light. Referring to FIG. 16 and FIG. 17, it can be seen that the darkest 90 degrees angles when viewed from below of the major axis direction angles of the second opening of the light blocking layer corresponding to the red R and blue B subpixels are not provided adjacent to each other, and the dark angle of 90 degrees and the bright angle of 0 degree are provided alternately. For example, when the darkest angles of 90 degrees are adjacent to each other, a difference in the reflection characteristics of external light can be greater, and therefore by providing the dark angle of 90 degrees and the bright angle of 0 degrees alternately, the difference in the reflection characteristics of external light can be reduced.

Referring to FIG. 10 to FIG. 12, FIG. 16, and FIG. 17, the red R, green G and blue B subpixels may be provided with the following major axis direction angles of the second opening.

Among the second opening corresponding to the red R subpixel and the second opening corresponding to the blue B subpixel, second openings having 90-degree difference in the major axis direction are provided alternately along a single diagonal direction, and among the major axis direction angles of 0 degrees and 90 degrees and 45 degrees and 135 degrees of the second opening corresponding to the red R subpixel and the second opening corresponding to the blue B subpixel, respectively, may be alternately provided along one diagonal direction.

In embodiments, among the second openings corresponding to the green G subpixels, second openings having a 90-degree difference in the major axis direction angle are provided alternately along the horizontal or vertical direction, and among the provided major axis direction angles of the second opening corresponding to the green G subpixel, directions of 0 degree and 90 degrees and 45 degrees and 135 degrees may be provided alternately along the horizontal direction or the vertical direction.

In embodiments, the second openings corresponding to the red R and blue B subpixels are provided such that the darkest and brightest angles are provided alternately one direction when viewed from one direction among a plurality of major direction angles along which the second openings are provided, and the one direction may be one of the diagonal directions other than the vertical or horizontal direction. In embodiments, another array adjacent to the same one direction may be provided alternately at an angle of intermediate brightness.

In embodiments, the second opening corresponding to the green G subpixel may be provided such that the darkest angle and the brightest angle are provided alternately along the vertical or horizontal direction when viewed from one direction among a plurality of major axis direction angles along which the second openings are provided, and in another array adjacent along the same vertical or horizontal direction, the second openings may be provided alternately with angles of intermediate brightness.

Overall, the second openings corresponding to the red R, green G, and blue B subpixels are provided such that the darkest angles when viewed from one of the plurality of major axis direction angles are not adjacent to each other.

Depending on embodiments, the one direction (diagonal direction), which is a reference of the second opening array corresponding to the red R and blue B subpixels and the vertical or horizontal direction of the reference of the second opening array corresponding to the green G subpixel may be applied interchangeably.

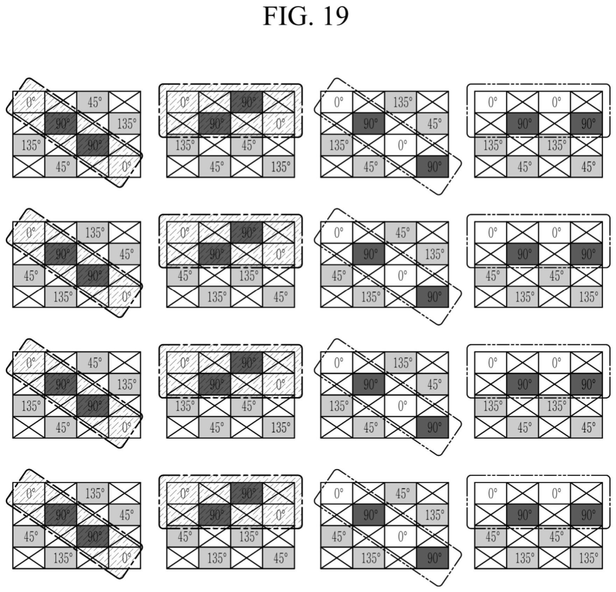

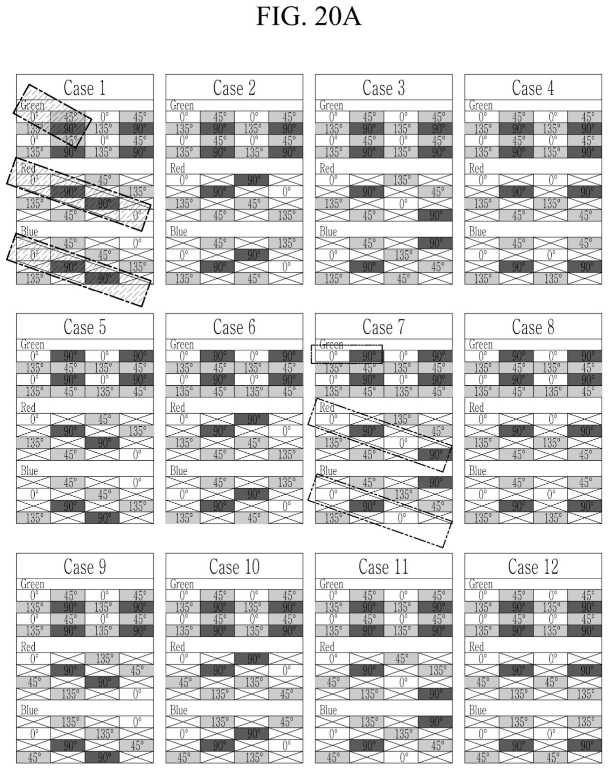

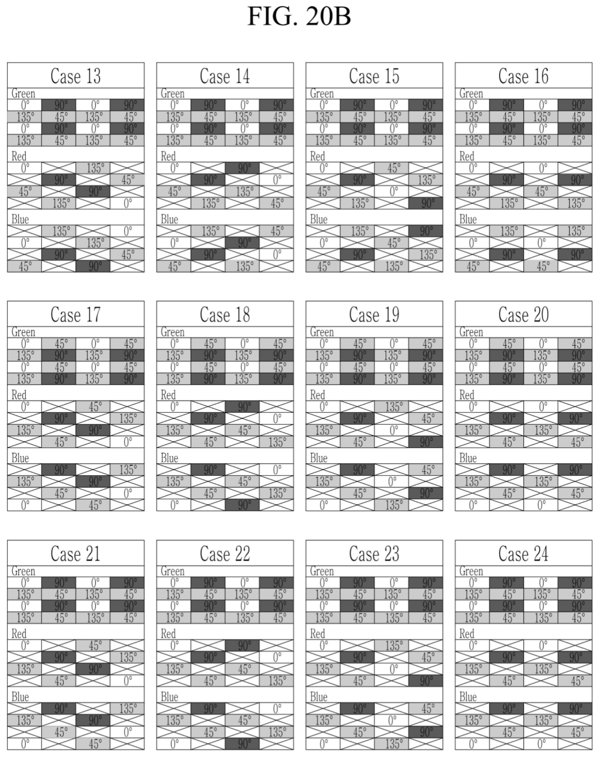

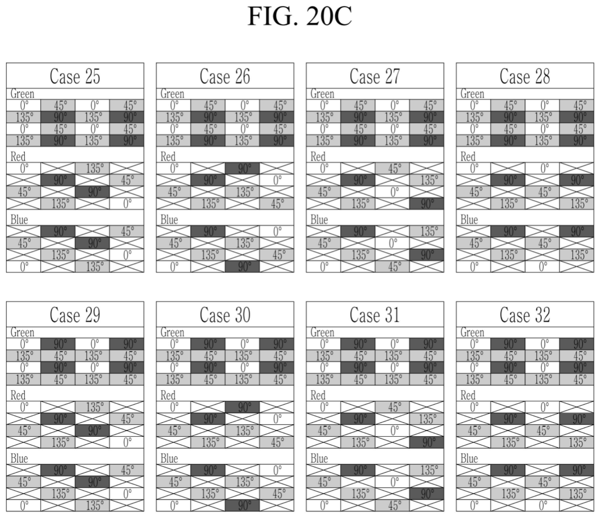

Hereinafter, various suitable arrangement methods of the angle of the major axis direction of the second opening of the light blocking layer will be further described with reference to FIG. 19 and FIG. 20.

FIG. 19 show major axis angles of second openings of a light blocking layer corresponding to a red subpixel of a first repeating unit pixel provided in a display panel according to an embodiment.

In FIG. 19, some embodiments where the second openings of the light blocking layer corresponding to the red subpixel can be alternately provided at angles (0 degree, 45 degrees, 90 degrees, and 135 degrees) along the four major axis directions are illustrated.

In the four columns of FIG. 19, the two columns on the left have 90-degree major axis direction angles provided adjacent to each other (indicated by dotted lines and diagonal lines), and the two columns on the right have 0-degree, 45-degree, or 135-degree major axis direction angles provided between 90-degree major axis direction angles (indicated by dotted lines).

As a result, it can be confirmed that when the second openings of the light blocking layer corresponding to the red subpixel are provided as in the two columns on the right of the arrangement of FIG. 19, it is possible to have improved external light visibility characteristics.

Hereinafter, a structure of various suitable first repeating unit pixels considering subpixels of green G and blue B will be described with reference to FIG. 20.

FIG. 20A to FIG. 20C show repeating unit pixels provided in a display panel according to an embodiment.

FIG. 20A to FIG. 20C illustrate a total of 32 embodiments (Cases), and angles along the major axis direction according to the positions of the second openings of the red, green, and blue light blocking layers are shown.

Among the 32 embodiments (Cases) shown in FIG. 20A to FIG. 20C, an embodiment (e.g., Case 1) in which the positions of the second openings of the light blocking layers of red, green, and blue have an angle of 90 degrees in the major axis direction are adjacent to each other may have a relatively high possibility of recognizing stains due to reflection of external light. In contrast, embodiments in which the positions of the second openings of the red, green, and blue light blocking layers have an angle of 90 degrees in the major axis direction angles are not adjacent to each other but are provided at 0 degrees, 45 degrees, or 135 degrees between 90 degrees may have a relatively low possibility of recognizing stains due to reflection of external light, and for example, Case 7, Case 8, Case 15, Case 16, Case 23, Case 24, Case 31, and Case 32 may have a low possibility of recognizing stains due to reflection of external light.

Hereinabove, the structure of the first repeating unit pixel, which includes the first minimum unit pixel was described. Hereinafter, a structure of a second repeating unit pixel including a second minimum unit pixel will be described with reference to FIG. 21 to FIG. 28.

FIG. 21 to FIG. 26 show an repeating unit pixel provided in a display panel.

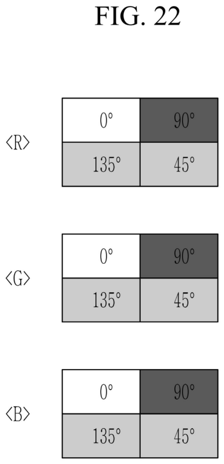

First, a second repeating unit pixel of FIG. 21 and FIG. 22 will be described.

FIG. 21 illustrates a planar structure of the second repeating unit pixel, and FIG. 22 illustrates an angle of an elliptical major axis direction of each subpixel included in the second repeating unit pixel in a table. In embodiments, the second repeating unit pixel is provided in a 2x2 array of the second minimum unit pixels of FIG. 8. In the embodiment of FIG. 21, the second minimum unit pixel is distinguished by a dotted line, and the second minimum unit pixel is distinguished using the green pixel as a reference. However, depending on embodiments, either a red pixel or a blue pixel may be used as a reference.

First, the second repeating unit pixel according to the embodiment of FIG. 21 will be described.

Contrary to that shown in FIG. 8, FIG. 21 does not show the first openings OPr, OPg, and OPb of the pixel defining layer, but only the second openings OPBMr, OPBMg, and OPBMb of the light blocking layer 220. In embodiments, the first openings OPr, OPg, and OPb provided within the second openings OPBMr, OPBMg, and OPBM have an eccentricity corresponding to the eccentricity of the second openings OPBMr, OPBMg, and OPBMb and may have an elliptical major axis direction that is the same as or similar to the elliptical major axis direction of the second openings OPBMr, OPBMg, and OPBMb. Contrary to that shown in FIG. 8, in FIG. 21, the second openings OPBMr, OPBMg, and OPBMb of the light blocking layer 220 are filled with diagonal lines, and each color is distinguished with a different diagonal line.

In the embodiment of FIG. 21, the second minimum unit pixels that constitute the second repeating unit pixels are separated by dotted lines, and it can be confirmed that the second minimum unit pixels are provided in a 2x2 array.

The four second minimum unit pixels included in the second repeating unit pixel may have different major axis direction angles and/or eccentricities, and the second repeating unit pixel provided in the display area DA may have the same major axis direction angle and eccentricity as the adjacent second repeating unit pixels.

The second openings OPBMr, OPBMg, and OPBMb of the same color included in the second repeating unit pixel of the embodiment of FIG. 21 have the same eccentricity. In embodiments, first openings of a pixel defining layer of the same color may also have the same eccentricity. In embodiments, a major axis direction angle of the second openings OPBMr, OPBMg, and OPBMb included in the second repeating unit pixel of the embodiment of FIG. 21 may be one of 0 degrees, 45 degrees, 90 degrees, and 135 degrees, and FIG. 21 additionally illustrates the major axis direction angle of the green G subpixel. In embodiments, the major axis direction angles are organized in the table of FIG. 22, and in FIG. 22, <R> shows the major axis direction angle of the red R subpixel, <G> shows the major axis direction angle of the green G subpixel, and <B> shows the major axis direction angle of the blue B subpixel.

In FIG. 22, the major axis direction angle is written in every cell, and because each second minimum unit pixel includes only one color subpixel, the table in FIG. 22 means the major axis direction angle of the corresponding color of the second minimum unit pixel at the corresponding position. For example, in FIG. 22, 0 degree provided in the first row and the first column of each table representing a red R subpixel, a green G subpixel, and a blue B subpixel represents the major axis direction angle of the second openings OPBMr, OPBMg, and OPBMb provided at the upper left side among the second openings OPBMr of the light blocking layer 220 corresponding to each of the red R subpixel, the green G subpixel, and the blue B subpixel in FIG. 21. For example, it can be confirmed that the second openings OPBMr, OPBMg, and OPBMb corresponding to the subpixels of each color included in the second minimum unit pixel provided at the upper left among the four second minimum unit pixels all have an angle of 0 degree in the major axis direction. Referring to FIG. 22, it can be confirmed that the second repeating unit pixel of the embodiment of FIG. 21 is provided such that all colors included in each second minimum unit pixel are provided with the same major axis direction angle.

Referring to FIG. 22, the second openings respectively corresponding to the red R subpixel, the green G subpixel, and the blue B subpixel have second openings having a major axis direction angle difference of 90 degrees and are provided alternately along the horizontal direction or the vertical direction, and among the provided major axis direction angles of the second openings corresponding to the red R subpixel, the green G subpixel, and the blue B subpixel, directions of 0 degree and 90 degrees and 45 degrees and 135 degrees may be provided alternately along the horizontal direction or the vertical direction.

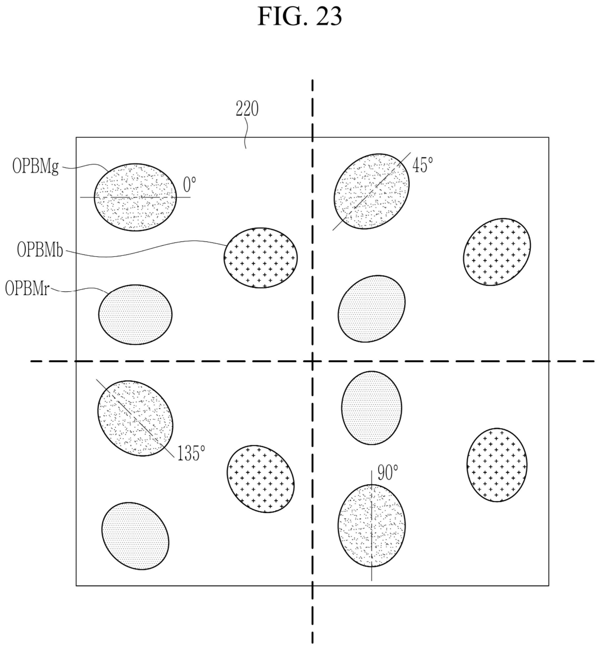

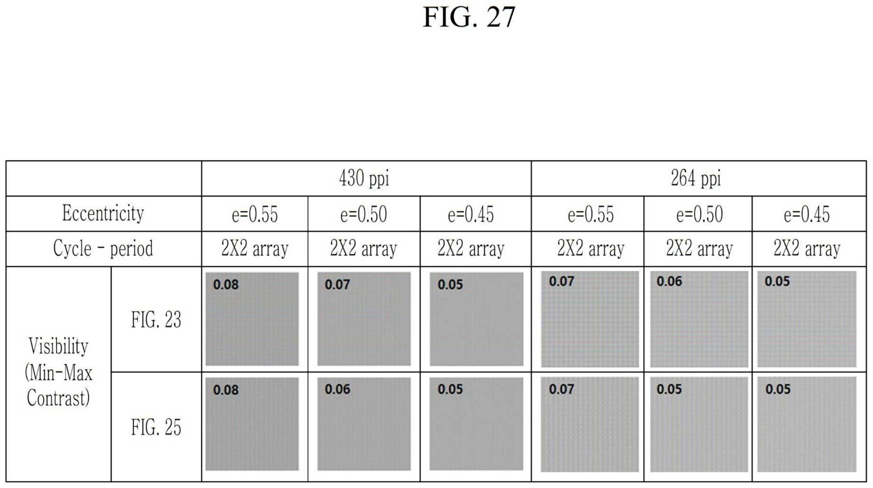

FIG. 23 to FIG. 26 illustrate various suitable modifications of embodiments. FIG. 23 to FIG. 26 are for comparing the effects of FIG. 27, and FIG. 25 and FIG. 26 may be the same embodiment as the embodiment of FIG. 21 and FIG. 22.

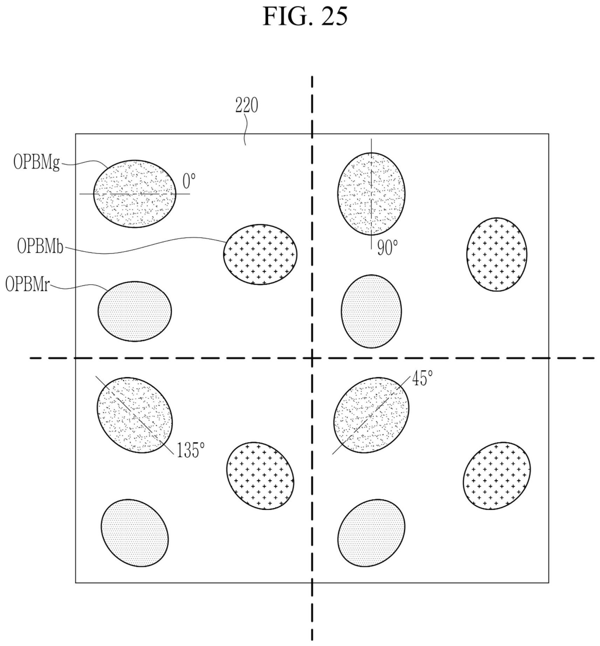

In the embodiments of FIG. 23 and FIG. 25, the second minimum unit pixel is distinguished by a dotted line, and the distinction in the embodiments of FIG. 23 and FIG. 25 is that the second minimum unit pixel is distinguished using the green pixel as a reference. However, depending on embodiments, either a red pixel or a blue pixel may be used as a reference.

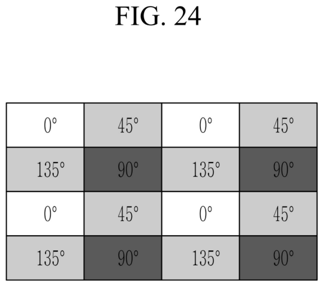

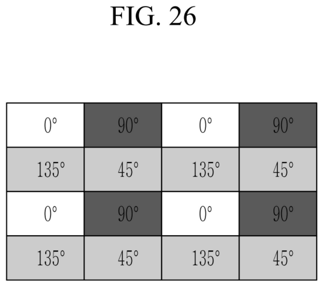

Comparing the embodiment of FIG. 23 and FIG. 24 with the embodiment of FIG. 25 and FIG. 26, in the embodiment of FIG. 23 and FIG. 24, the brightest 0 degree and the darkest 90 degrees are provided adjacent to each other in the diagonal direction, while in the embodiment of FIG. 25 and FIG. 26, the brightest 0 degree and the darkest 90 degrees are provided adjacent to each other in the horizontal direction.

Hereinafter, the reflection characteristics of external light according to the change in eccentricity for the embodiment of various suitable second repeating unit pixels shown in FIG. 23 to FIG. 26 will be described with reference to FIG. 27.

FIG. 27 summarizes the characteristics of reflected light for some embodiments.

The visibility value described in FIG. 27 is a difference (Min-Max Contrast) between the maximum value and the minimum value of reflected light luminance depending on the position in the first repeating unit pixel. The larger the difference, the more likely it is that the reflection of external light will be perceived as a stain by the user.

In FIG. 27, the visibility of external light is simulated by changing an eccentricity value e of the second opening of the light blocking layer 220 of green G to 0.55, 0.50, and 0.45 in the second repeating unit pixel where the second minimum unit pixel is provided in a 2x2 array like in FIG. 23 to FIG. 26, and the visibility value according to the simulation is described. FIG. 27 simulates two different light emitting display panels, one with a pixel density of 430 ppi and the other with a pixel density of 264 ppi. In embodiments, the 430 ppi light emitting display panel may be used in a small electronic device such as a mobile phone, and the 264 ppi light emitting display panel may be used in a medium or large electronic device such as a pad.

Referring to FIG. 27, it can be confirmed that as the eccentricity value e decreases, the value of visibility also decreases. Therefore, the smaller the eccentricity value e of the elliptical shape of the opening included in the second repeating unit pixel, the less external light may be recognized. The eccentricity value e of the second opening of the light blocking layer 220 of green G may have a value greater than or equal to 0.40 and less than or equal to 0.55, and depending on embodiments, may have an eccentricity value e smaller than 0.40. In embodiments, the eccentricity value e of the second opening of the light blocking layer corresponding to the red R and blue B subpixels may also have a value similar to that of green G.

In the embodiment of having the same eccentricity value e in FIG. 27, providing the major axis direction of the second opening as in the embodiment of FIG. 25 and FIG. 26 can prevent or reduce the reflection stain of external light from being recognized more than in the embodiment of FIG. 23 and FIG. 24.

Referring to the embodiment of FIG. 25 and FIG. 26, in the embodiment, the brightest 0 degree and the darkest 90 degrees are adjacent in the horizontal direction when viewed from below, but are not adjacent in the diagonal direction. For example, when the darkest angle, 90 degrees and the brightest angle, 0 degree, are provided in the horizontal direction rather than the diagonal direction, a difference in the reflection characteristics of external light may appear smaller.

Referring to FIG. 22 and FIG. 26, the red R, green G and blue B subpixels may be provided with the following major axis direction angles of the second opening:

The second opening corresponding to the red R subpixel, the green G subpixel, and the blue B subpixel may be provided such that the darkest angle and the brightest angle are provided alternately along the vertical or horizontal direction when viewed from one of a plurality of major axis direction angles, and the intermediate brightness angles are provided alternately in another array adjacent along the same vertical or horizontal direction.

Overall, the second openings corresponding to the red R, green G, and blue B subpixels are provided such that the darkest angles when viewed from one of the plurality of major direction angles are not adjacent to each other.

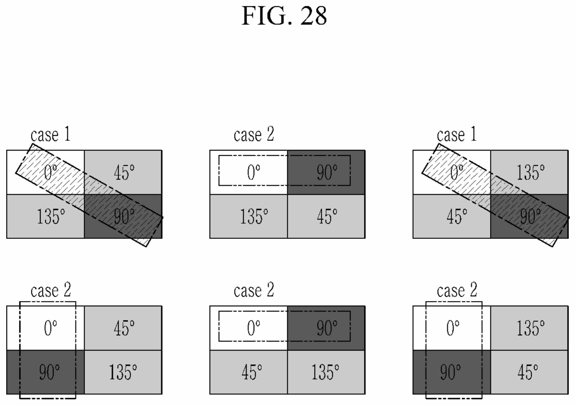

Hereinafter, various suitable arrangement methods of the angle of the major axis direction of the second opening of the light blocking layer will be described with reference to FIG. 28.

FIG. 28 shows a major axis angle of a second opening of a light blocking layer corresponding to one subpixel of the second repeating unit pixel on a display panel according to an embodiment.

FIG. 28 shows six cases (e.g., embodiments) where the second opening of the light blocking layer corresponding to the green subpixel is alternately provided at angles (0 degree, 45 degrees, 90 degrees, and 135 degrees) along the four major axis directions.

FIG. 28 illustrates "case 1" where the brightest 0 degree and the darkest 90 degrees are adjacent in the diagonal direction when viewed from below, and "case 2" where the brightest 0 degree and the darkest 90 degrees are adjacent in the horizontal direction or vertical direction when viewed from below.

As confirmed in FIG. 27, "case 2", where the brightest 0 degree and the darkest 90 degrees are placed adjacently in the horizontal direction, has a small difference in the reflection characteristics of external light and no stain is visible, and thus it has improved visibility characteristics with respect to external light.

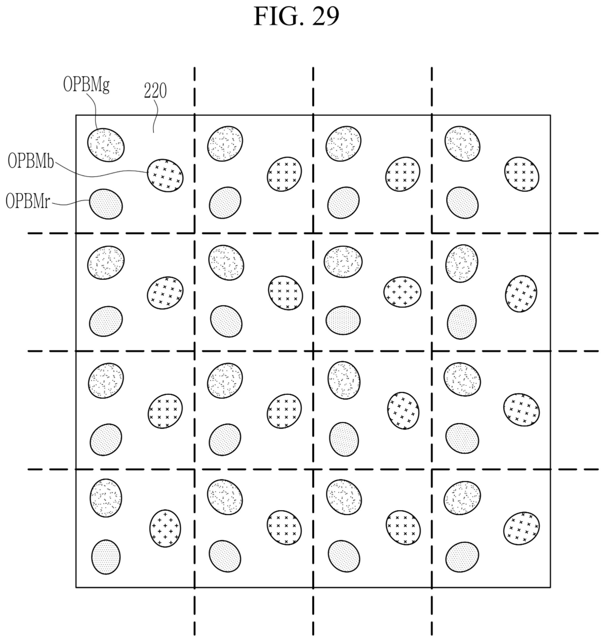

In the above, an embodiment in which the minimum unit pixels are provided into a 2x2 array to form one repeating unit pixel was described. However, the number of minimum unit pixels may be increased depending on embodiments, and in the following, an embodiment in which a 4x4 array is provided to form one repeating unit pixel will be described with reference to FIG. 29.

FIG. 29 shows an repeating unit pixel provided in a display panel according to an embodiment.

The embodiment of FIG. 29 is an embodiment in which the second repeating unit pixels, like FIG. 8, are provided into a 4x4 array.

Similar to FIG. 21, FIG. 29 does not illustrate the first openings OPr, OPg, and OPb of the pixel defining layer and illustrates only the second openings OPBMr, OPBMg, and OPBMb of the light blocking layer 220. In embodiments, the first openings OPr, OPg, and OPb provided within the second openings OPBMr, OPBMg, and OPBMb have an eccentricity corresponding to the eccentricity of the second openings OPBMr, OPBMg, and OPBMb and may have an elliptical major axis direction that is the same as or similar to the elliptical major axis direction of the second openings OPBMr, OPBMg, and OPBMb. In FIG. 29, as in FIG. 21, the second openings OPBMr, OPBMg, and OPBMb of the light blocking layer 220 is filled with the diagonal line, and each color is distinguished by a different diagonal line.

In the embodiment of FIG. 29, the second minimum unit pixels forming the second repeating unit pixels are separated by a dotted line, and it can be confirmed that the second minimum unit pixels are provided in a 4x4 array.

The 16 second minimum unit pixels included in the second repeating unit pixel may have different major axis direction angles and/or eccentricities, and the second repeating unit pixel provided in the display area DA may have the same major axis direction angle and eccentricity as the adjacent second repeating unit pixels.

The second openings OPBMr, OPBMg, and OPBMb of the same color included in the second repeating unit pixel of the embodiment of FIG. 29 have the same eccentricity. In embodiments, the first opening of the pixel defining layer of the same color may also have the same eccentricity. In embodiments, the angles along the major axis directions of the second openings OPBMr, OPBMg, and OPBMb included in the second repeating unit pixel of the embodiment of FIG. 29 include 0 degree, 45 degrees, 90 degrees, and 135 degrees and may be provided at various suitable angles, and the major axis directions may be provided at regular angular intervals. In embodiments, the number of angles in the major axis direction may be 16 or more, and the interval between the major axis directions may have an angle of 22.5 degrees or less. The second repeating unit pixel of the embodiment of FIG. 29 may be provided such that all colors included in each second minimum unit pixel have the same major axis direction angle.

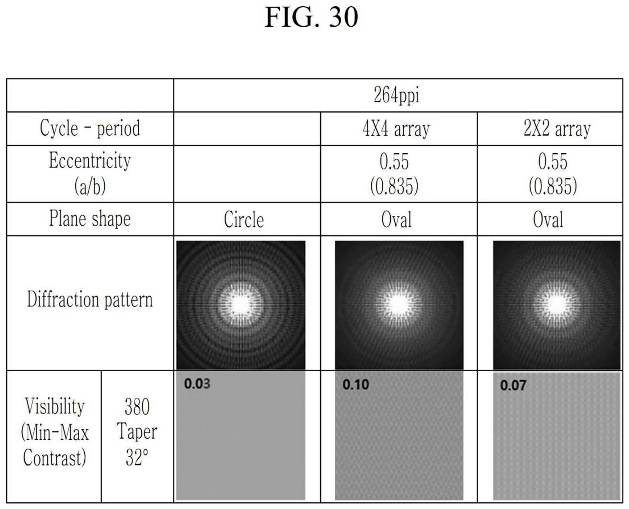

As shown in FIG. 29, the features of the embodiment in which the minimum unit pixel is provided in a 4x4 array will be further described with reference to FIG. 30 to FIG. 35.

FIG. 30 to FIG. 35 show features of a display panel according to an embodiment.

First, in FIG. 30 to FIG. 32, characteristic differences between the embodiment where the minimum unit pixel is provided in a 4x4 array and the embodiment where the minimum unit pixel is provided in a 2x2 array, by comparing them with a comparative example.

In FIG. 30, a light emitting display panel with a pixel count of 264 ppi was simulated as a reference. The comparative example of FIG. 30 is an embodiment in which a planar shape of the second opening and a planar shape of the first opening are both provided as circles (e.g., generally circles), and the embodiment in which the minimum unit pixels are provided in a 4x4 array and the embodiment in which the minimum unit pixels are provided in a 2x2 array have elliptical shapes (e.g., generally elliptical shapes) with the same eccentricity value. In FIG. 30, "a/b" represents a ratio of the minor axis length to the major axis length. Therefore, a difference between the embodiment where the minimum unit pixels are provided in a 4x4 array and the embodiment where the minimum unit pixels are provided in a 2x2 array is a difference in the size of the repeating unit pixels. The "380 Taper 32°" in FIG. 30 indicates that a side surface of the pixel defining layer (refer to 380 in FIG. 6) has a taper angle of 32 degrees relative to the horizontal. This is the result of simulation with the taper angle set because external light is reflected and recognized from the side surface of the pixel defining layer.

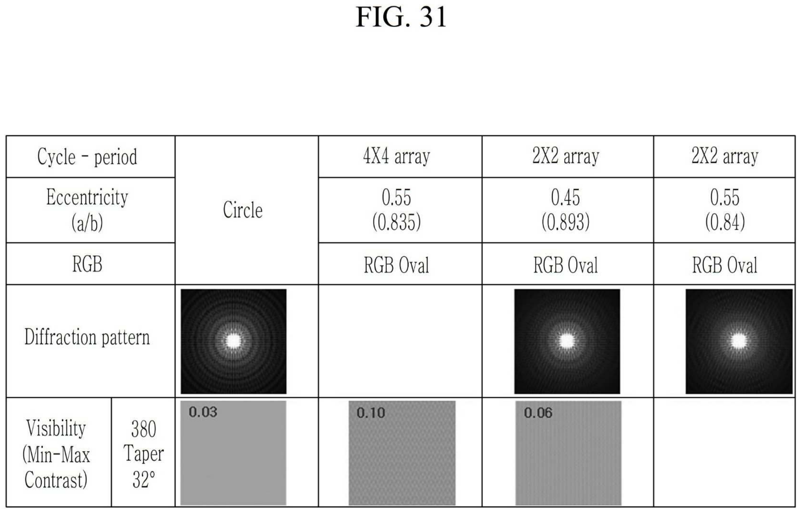

FIG. 31 additionally includes an embodiment of FIG. 30 in which the minimum unit pixels are provided in a 2x2 array.

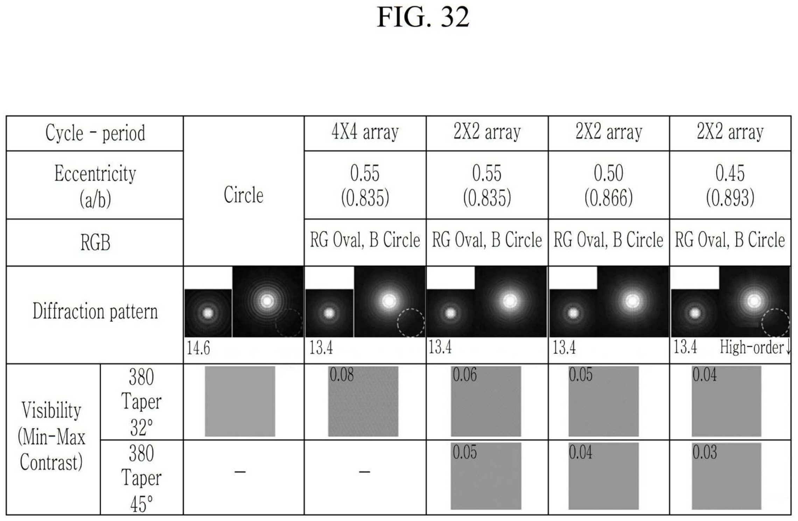

In the embodiment of FIG. 32, contrary to that shown in FIG. 30 and FIG. 31, some subpixels form circular first and/or second openings instead of elliptical first and/or second openings. In embodiments, FIG. 32 additionally includes an embodiment in which the minimum unit pixel is provided in a 2x2 array, and an embodiment in which the taper angle of the side surface of the pixel defining layer (refer to 380 in FIG. 6) is 45 degrees with respect to the horizontal, including "380 Taper 45°" was simulated.

Referring to FIG. 32, depending on embodiments, either the second opening or the first opening may have a planar shape other than an ellipse (e.g., generally an ellipse), for example a circle (e.g., generally a circle). For example, the red R and the green G may be provided into an ellipse (e.g., generally an ellipse) and the blue B may be provided into a circle (e.g., generally a circle), or the red R and the blue B may be provided into an ellipse (e.g., generally an ellipse) and the green G may be provided into a circle (e.g., generally a circle), or the green G and the blue B may be provided into an ellipse (e.g., generally an ellipse) and the red R may be provided into a circle (e.g., generally a circle). In embodiments, depending on embodiments, it is possible to form two colors in a non-elliptical planar shape (e.g., a circle or generally a circle), or one color in an elliptical planar shape (e.g., a generally elliptical planar shape).

Referring to the visibility values in FIG. 30, the comparative example has the smallest value, but the diffraction pattern is so severe that it is difficult to use a circular opening (e.g., generally a circular opening). There is no significant difference in the diffraction pattern between the embodiment where the minimum unit pixels are provided in a 4x4 array and the embodiment where the minimum unit pixels are provided in a 2x2 array, but the visibility value of the embodiment where the unit pixels are provided in a 4x4 array is larger.

In embodiments, in FIG. 31, as shown in FIG. 30, it can be confirmed that the comparative example has the lowest visibility value, but the diffraction pattern is strong, and thus it is necessary or useful to form an elliptical opening (e.g., a generally elliptical opening). In embodiments, there is no significant difference in the diffraction pattern between the embodiment where the minimum unit pixels are provided in a 4x4 array and the embodiment where the minimum unit pixels are provided in a 2x2 array, but the visibility value of the embodiment where the unit pixels are provided in a 4x4 array is larger. In the embodiment where the minimum unit pixels are provided in a 2x2 array, it can be confirmed that there is a change in the diffraction pattern as the eccentricity changes, but the difference is not large.

In FIG. 32, the red R and green G subpixels form the first opening and second opening as ellipses (e.g., generally ellipses) in the embodiment, but the blue B subpixels form the first opening and second opening as circles (e.g., generally circles).

Referring to FIG. 32, the degree of each diffraction pattern is also expressed numerically, and it can be confirmed that the degree of the diffraction pattern in the comparative example is 14.6, which is larger than the degree of the diffraction pattern of other embodiments, which is 13.4. In all embodiments of FIG. 32, the degree of the diffraction pattern is the same in the embodiments, as it is all 13.4 regardless of the number of minimum unit pixels included or the difference in eccentricity.

Referring to the visibility values in FIG. 32, the visibility value of the 4x4 array embodiment is relatively greater than that of the 2x2 array embodiment. Therefore, it can be confirmed that using the 2x2 array embodiment is less likely to cause stain to be visible due to external light than using the 4x4 array embodiment.

In embodiments, it can be confirmed that the visibility value decreases as the eccentricity decreases among the same 2x2 array embodiments. Therefore, the lower the eccentricity value of the ellipse shape of the first opening and/or second opening, the lower the possibility of staining due to external light being recognized. The eccentricity value of the first opening and/or second opening may have a value greater than or equal to 0.40 and less than or equal to 0.55, and may have an eccentricity value smaller than 0.40 depending on embodiments.

In embodiments, in FIG. 32, it can be confirmed that the visibility value decreases as the taper angle of the side of the pixel defining layer (refer to 380 in FIG. 6) increases. Therefore, it can be confirmed that the steeper the side surface of the pixel defining layer (refer to 380 in FIG. 6) is provided, the lower the possibility of staining due to external light being recognized.

From the above, it can be confirmed that using the embodiment that includes repeating unit pixels where the minimum unit pixels are provided in a 2x2 array is less likely to cause visible staining due to external light than using the embodiment that includes repeating unit pixels where the minimum unit pixels are provided in a 4x4 array.

In embodiments of using repeating unit pixels provided in a 4x4 array, a difference in a reflectance value of external light according to an angle may be additionally minimized, reduced, or provided within a set or certain range of values such that the overall reflection characteristic of external light is similar, and the difference in reflectance of external light is not recognized by the user.

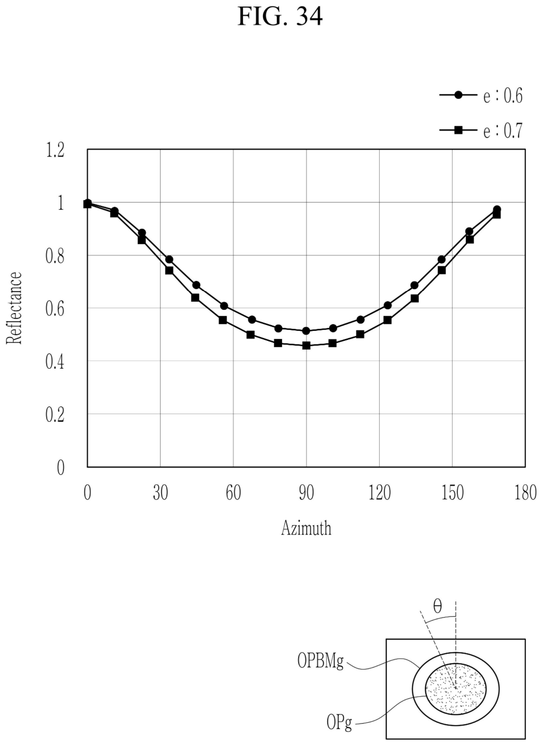

In this regard, the relationship between the angle considering the reflectivity and the direction of the second opening will be described in more detail with reference to FIG. 33 and FIG. 34.

In FIG. 33 and FIG. 34, results of simulating reflection characteristics according to the azimuth θ using Light Tools for a second opening OPBMg of one light blocking layer and a first opening OPg of the corresponding pixel defining layer are shown. In embodiments, the azimuth θ is an angle on the horizontal plane measured clockwise from the reference direction (usually 0 degree (°)), and is an angle measured after projecting a specific angle onto the horizontal plane, corresponding to 0°, 90°, 180°, and 270° as shown in the drawing of FIG. 33.

Referring to FIG. 33, a second opening OPBMg of the light blocking layer and a first opening OPg of the pixel defining layer have a major axis direction of the horizontal direction (0 degrees), and it can be confirmed that the corresponding reflection characteristics have the highest reflectivity at 0 degree and 180 degrees with the azimuth angle θ as a reference. Therefore, the reflectance of external light may be the largest in the direction perpendicular (e.g., substantially perpendicular) to the major axis direction of the second opening OPBMg of the light blocking layer, and the reflectance of external light may be the smallest in the direction parallel (e.g., substantially parallel) to the major axis direction.

FIG. 34 shows a graph of reflectance according to the azimuth θ, and it can be confirmed that the maximum reflectance is at 0 and 180 degrees, and the minimum reflectance is at 90 degrees. In embodiments, the graph of FIG. 34 also shows the change in the reflectance of external light according to the eccentricity value e, and it can be confirmed that as the eccentricity value e of the second opening OPBMg of the light blocking layer increases, the difference in the reflectance of external light increases. For example, because the reflectance at the azimuth of 90 degrees increases as the eccentricity value e increases with reference to the reflectance at 0 degrees azimuth, it can be confirmed that the visibility value, which is the difference between the maximum value and minimum value of reflected luminance (Min-Max Contrast), also increases.

As shown in FIG. 33 and FIG. 34, after calculating a reflectance value according to the azimuth for the second opening OPBMg of the light blocking layer, the difference in the reflectance value of external light according to the angle is minimized, reduced, or provided within a set or certain range of values, and thus the overall reflection characteristic of the external light is provided to be similar, and the difference in reflectance of the external light is not recognized by the user.

Therefore, for a 4x4 array of repeating unit pixels having relatively large visibility values, the reflectance value may be additionally considered and the angle/eccentricity of the second opening may be adjusted to reduce the difference in reflectance values such that the reflection of external light is not visible.

In embodiments, when the difference in reflectance values is set to be smaller for not only a 4x4 array of repeating unit pixels but also a 2x2 array of repeating unit pixels, the difference in reflectance of the external light may not be viewed by the user. Such an embodiment may be applied to both the first repeating unit pixel and the second repeating unit pixel. For example, the first repeating unit pixel may be provided with a small difference in the reflectance value by providing it according to the embodiments of FIG. 9 to FIG. 12, and the second repeating unit pixel may be provided with a small difference in the reflectance value by providing it according to the embodiments of FIG. 21 and FIG. 22. Further, depending on embodiments, the eccentricity may be changed, or some openings may be provided into circles (e.g., generally circles) rather than ellipses.

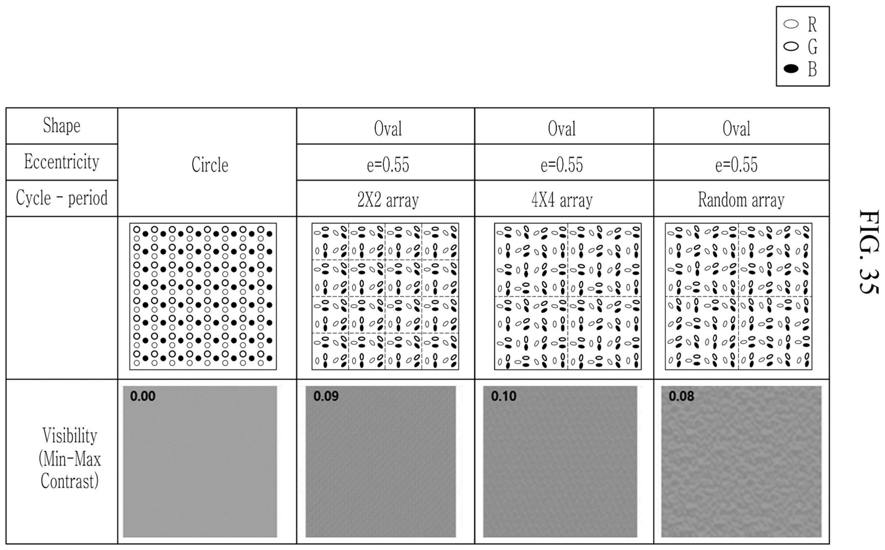

Depending on embodiments, the first opening and/or second opening may be randomly arranged such that there are no repeating unit pixels provided repeatedly within the display area DA. This will be further described with reference to FIG. 35.

FIG. 35 shows a comparative example in which planar shapes of the second opening and first opening are both provided as circles (e.g., generally circles), a 2x2 array embodiment, a 4x4 array embodiment, a randomly arranged embodiment, and the reflection characteristics of them.

In FIG. 35, the 2x2 arrangement embodiment, the 4x4 array embodiment, and the randomly arranged embodiment all have the same eccentricity value e. In the 2x2 array embodiment and the 4x4 array embodiment of FIG. 35, the repeating unit pixels that serve as the basis for repetition are separated by dotted lines. The randomly arranged embodiment does not include dotted lines as there are no repeating unit pixels.

Referring to FIG. 35, a visibility value, which is a difference between the maximum value and the minimum value of luminance of reflected line (Min-Max Contrast), is the smallest in the comparative example, but since the plane shapes of the second opening and the first opening are both provided as circles (e.g., generally circles), there is a problem of a strong diffraction pattern, as shown in FIG. 30 and FIG. 31, and therefore an embodiment including at least one ellipse is used.

In FIG. 35, the visibility value is 0.08 in the randomly arranged embodiment, which is smaller than the 4x4 array embodiment and the 2x2 array embodiment. As a result, it can be confirmed that using the randomly arranged embodiment is less likely to cause staining due to external light to be visible than the 4x4 array embodiment and the 2x2 array embodiment.

Above, various suitable embodiments and their corresponding effects were described.

A representative example among the various embodiments described above may be summarized into Table 1 below.

**(Table 1)**

| Item | Theory | Method |
|---|---|---|
| Reduce arrangement period (2x2 array) | Reduce period of visibility of external light stain | Reduce the minimum number of unit pixels in repeating unit pixel (e.g., a 2x2 array, where the angle difference along the major axis direction of the ellipse shape is 45 degrees) - FIG. 9, FIG. 13 to FIG. 17, FIG. 19, FIG. 20). Reduces arrangement period and improves visibility of external light stain. |
| | | Since the elliptical angle is recognized in the diffraction pattern, the eccentricity of the ellipse is reduced to improve the visibility of external light stain. |
| | | All openings may be elliptical (e.g., generally elliptical), and at least one of the elliptical openings may be changed to a circular or non-elliptical shape (e.g., a generally circular or non-elliptical shape). That is, red R and green G may be provided into an ellipse (e.g., generally an ellipse) and blue B into a circle (e.g., generally a circle), or red R and blue B may be provided into an ellipse (e.g., generally an ellipse) and green G into a circle (e.g., generally a circle), or green G and blue B may be provided into an ellipse (e.g., generally an ellipse) and red R into a circle (e.g., generally a circle). |
| Ellipse arrangement optimization (4x4 array) | Minimize difference in external light reflectance between adjacent pixel rows or columns. | The difference in elliptical reflectance values is minimized, reduced, or provided within a set or certain range of values for each observation direction. |
| | | Arrangement with minimized pattern visibility in reflection emulation image. |
| Reduce arrangement period and optimize arrangement (2x2 array) | Minimize the difference in external light reflectance between adjacent pixel rows or columns and reduce the stain visible period of external line | Minimized pattern visibility arrangement of the second row is additionally applied to the 2x2 array of the first row. Refer to embodiments of FIG. 9 to FIG. 12 or embodiments of FIG. 21 and FIG. 22. |
| | | All openings may be elliptical (e.g., generally elliptical), and at least one of the elliptical openings may be changed to a circular or non-elliptical shape (e.g., a generally circular or non-elliptical shape). That is, red R and green G may be provided into an ellipse (e.g., generally an ellipse) and blue B into a circle (e.g., generally a circle), or red R and blue B may be provided into an ellipse (e.g., generally an ellipse) and green G into a circle (e.g., generally a circle), or green G and blue B may be provided into an ellipse (e.g., generally an ellipse) and red R into a circle (e.g., generally a circle). |
| Random arrangement (FIG. 35) | Improves periodic staining of external light through aperiodic arrangement. | The major axis direction of the elliptical opening is randomly arranged. Repeating unit pixels may not be included in the display area. All openings may be elliptical (e.g., generally elliptical), and at least one of the elliptical openings may be changed to a circular or non-elliptical shape (e.g., a generally circular or non-elliptical shape). That is, red R and green G may be provided into an ellipse (e.g., generally an ellipse) and blue B into a circle (e.g., generally a circle), or red R and blue B may be provided into an ellipse (e.g., generally an ellipse) and green G into a circle (e.g., generally a circle), or green G and blue B may be provided into an ellipse (e.g., generally an ellipse) and red R into a circle (e.g., generally a circle). |

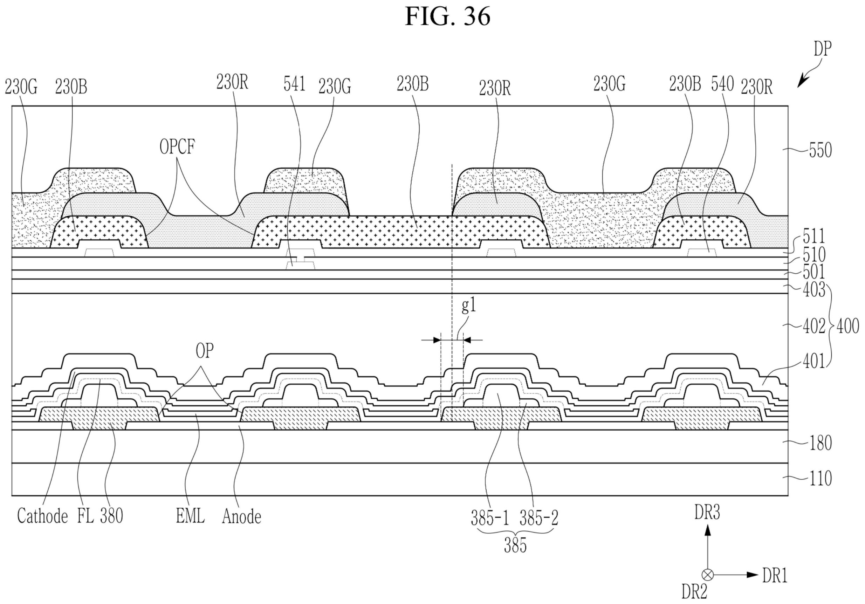

Depending on embodiments, instead of the light blocking layer 220, at least two of color filters 230R, 230G, and 230B may form a light blocking region of the overlapped color filter. Hereinafter, an embodiment in which a light blocking layer is not included and a light blocking region of a color filter in which at least two color filters 230R, 230G, and 230B overlap will be described with reference to FIG. 36 to FIG. 38.

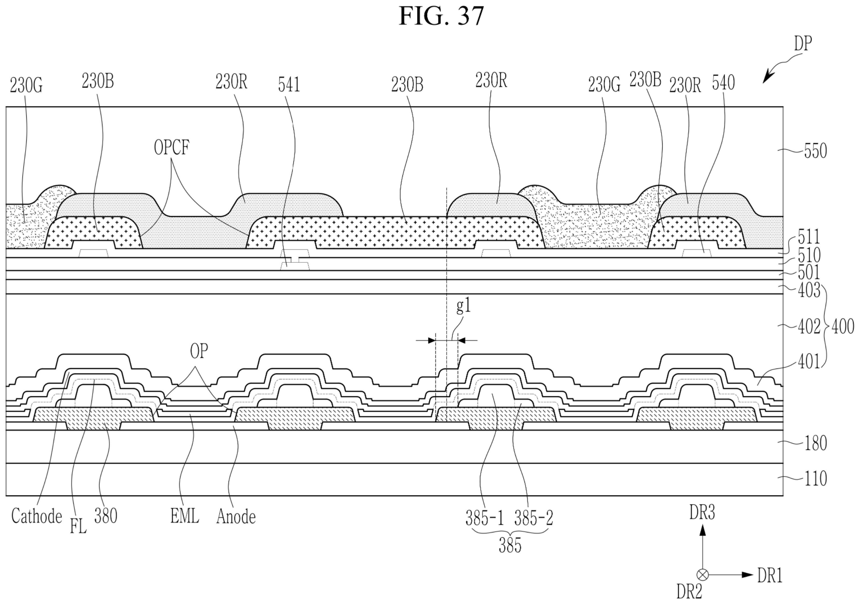

First, referring to FIG. 36 and FIG. 37, a deformation structure of FIG. 6 will be described.

FIG. 36 and FIG. 37 are schematic cross-sectional views of a display panel according to another embodiment.

Hereinafter, referring to FIG. 36, a structure of a light emitting display panel DP according to an embodiment will be described, and a description of the same part of FIG. 6 is omitted.

A light emitting display panel DP according to an embodiment of FIG. 36 may form a light emitting diode on a substrate 110 to display an image, and a plurality of sensing electrodes 540 and 541 are included to sense a touch and color filters 230R, 230G, and 230B are included to have color characteristics of the color filters 230R, 230G, and 230B with respect to light emitted from the light emitting diode. A light blocking layer provided in black color and blocking visible light may not be provided, and instead of the light blocking layer, at least two or more color filters may be overlapped to block visible light.

A region where at least two or more color filters overlap to block visible light is called a light-blocking region, and in the embodiment of FIG. 36, a blue color filter 230B, a red color filter 230R, and a green color filter 230G are sequentially stacked. The order in which color filters are stacked may suitably vary depending on embodiments.

In embodiments, a polarizing plate is not on a front surface of the light emitting display panel DP according to the embodiment of FIG. 36, and instead, a pixel defining layer 380 is provided with a black color organic material, and a light blocking region in which at least two or more color filters overlap is provided above the pixel defining layer 380, and thus even if external light is incident on the inside, it is not reflected from an anode Anode and/or the like and transmitted to a user.

In embodiments, the color filters 230R, 230G, and 230B are on a third sensing insulation layer 511. The color filters 230R, 230G, and 230B include a red color filter 230R that transmits red light, a green color filter 230G that transmits green light, and a blue color filter 230B that transmits blue light. Each of the color filters 230R, 230G, and 230B may overlap on a plane with the anode Anode of the light emitting diode. Because light emitted from the light emitting layer EML may be emitted while changing to the corresponding color as it passes through the color filter, all light emitted from the light emitting layer EML may have the same color. In embodiments, the light emitting layer EML may display different colors of light and enhance the displayed color by allowing the light passing through a color filter of the same color.

Depending on embodiments, the color filters 230R, 230G, and 230B may be replaced with a color conversion layer, or a color conversion layer may further be included. The color conversion layer may include quantum dots.

In the embodiment of FIG. 36, a light blocking layer provided in black color to block (or reduce transmission of) visible light is not provided, and instead of the light blocking layer, a light blocking region is provided by overlapping at least two or more color filters, thereby replacing the light blocking layer. In the embodiment of FIG. 36, the blue color filter 230B, the red color filter 230R, and the green color filter 230G are sequentially stacked in the light blocking region. The order in which color filters are stacked may vary depending on embodiments.

In the light blocking region where at least two or more color filters are overlapped may overlap the sensing electrodes 540 and 541 on a plane, and may not overlap the anode Anode on a plane. This is to prevent the anode Anode and the light emitting layer EML that can display an image from being obscured by the light blocking region and the sensing electrodes 540 and 541.

Referring to FIG. 36, the light blocking region of the color filter, in which three color filters are overlapped, is provided only in an area overlapping the pixel defining layer 380 on a plane, and one side of the light blocking region of the color filter is provided inward from the corresponding side of the pixel defining layer 380.

Only one color filter may be provided in a region excluding the light blocking region, and light of a color of the corresponding color filter is transmitted to form a light transmitting region of the color filter. Hereinafter, a light transmitting region of a color filter, where only one color filter is provided, is also called a second opening OPCF of the light blocking region because light is transmitted therethrough. The second opening OPCF of the light blocking region is an opening provided in the light blocking region where at least two or more color filters overlap, and may correspond to a region where only one color filter is provided. In embodiments, the second opening OPCF of the light blocking region of the color filter may correspond to the second opening OPBM of the light blocking layer 220 described above.

The area of the second opening OPCF of the light blocking region is provided larger than the opening OP of the pixel defining layer 380, and on a plane, the opening OP of the pixel defining layer 380 may be provided within the second opening OPCF of the light blocking region.

In embodiments, one side of the spacer 385 is provided inwardly by a set or certain distance g1 from the corresponding side of the pixel defining layer 380, and the spacer 385 is also provided inwardly with respect to one side of the light blocking region. As a result, when viewed from the front of the display panel DP, the spacer 385 may not be visible due to the light blocking region.

When external light is incident, it may pass through the second opening OPCF of the light blocking region of the color filter and then be reflected from the side wall of the opening OP of the pixel defining layer 380. The side wall of the opening OP of the pixel defining layer 380 is curved, and thus color separation occurs depending on the reflected position, and the color of the reflected light may appear as various suitable colors like a rainbow. Because such color-separated reflected light may easily be seen by the user and cause deterioration of display quality, the second opening OPBM of the light blocking layer 220 in the embodiment of FIG. 7 may be replaced with the second opening OPCF of the light blocking region of the color filter. For example, at least one selected from the second opening OPCF of the light blocking region of the color filter and the opening OP of the pixel defining layer 380 is provided into an ellipse (e.g., generally an ellipse), and a direction or eccentricity of the ellipse is arranged in various suitable ways to reduce color separation or to allow white reflected light to be recognized. Depending on embodiments, it may be provided to have a shape similar to an ellipse rather than an ellipse, and its direction or eccentricity may be changed in various suitable ways. In embodiments, various suitable modifications of the second opening OPBM of the light blocking layer 220 and the corresponding opening OP of the pixel defining layer 380 described above may also be applied to the second opening OPCF of the light blocking region of the color filter and the opening OP of the pixel defining layer 380.

A planarization layer 550 covering the color filters 230R, 230G, and 230B is on the color filters 230R, 230G, and 230B. The planarization layer 550 is for planarizing an upper surface of the light emitting display panel and may be a transparent organic insulator including one or more materials selected from the group consisting of poly imide, polyamide, acryl resin, benzocyclobutene, and phenol resin.

Depending on embodiments, a low-refractive layer and an additional planarization layer may be on the planarization layer 550 to improve frontal visibility and light output efficiency of the display panel. Light may be refracted and emitted toward the front by the additional planarization layer having low refractive index and high refractive index characteristics. In this embodiment, depending on embodiments, the planarization layer 550 may be omitted and the low-refractive layer and the additional planarization layer may be directly on the color filter 230.

In the present embodiment, a polarizing plate may not be included above the planarization layer 550. For example, the polarizing plate may serve to prevent or reduce display quality deterioration when external light is incident and visible to a user while being reflected from the anode Anode and/or the side wall of the opening OP of the pixel defining layer 380. The polarizing plate has a drawback of consuming more electric power to display a set or certain luminance because it not only reduces the reflection of external light, but also reduces the light emitted from the light emitting layer EML. To reduce power consumption, the light emitting display device according to the present embodiment may not include a polarizing plate.

In embodiments, in the present embodiment, the pixel defining layer 380 covers the side of the anode Anode to reduce the amount of reflection from the anode, Anode and a light blocking region in which at least two or more color filters overlap is provided to reduce the amount of incident light, thereby already including a structure that prevents deterioration of display quality due to reflection. Therefore, there is no need to form a polarizing plate separately on the front surface of the light emitting display panel DP.

In the embodiment of FIG. 36, an embodiment in which the light blocking region overlapped with at least two or more color filters is provided by overlapping three color filters was described. Depending on embodiments, two color filters may be overlapped to form a light blocking region of the color filter, as illustrated in FIG. 37.

FIG. 37 is a drawing corresponding to FIG. 6 and FIG. 36, and differs from FIG. 36 only in the color filters 230R, 230G, and 230B, and the lower structure of the third sensing insulation layer 511 is the same as FIG. 36. Hereinafter, an upper structure of the third sensing insulation layer 511, which is different from FIG. 36 will be mainly described.

Referring to FIG. 37, a light blocking layer blocking visible light is not provided, and the blue color filter 230B and the red color filter 230R are sequentially overlapped to block visible light. The order in which color filters are stacked may suitably vary depending on embodiments.

In embodiments, a light blocking region where two color filters overlap is where the blue color filter 230B and the red color filter 230R overlap, and some regions of the light blocking region of the color filters also have a portion where the green color filter 230G overlaps. In the embodiment of FIG. 37, the green color filter 230G is not provided in the entire light blocking region of the color filter, unlike the embodiment of FIG. 36, and thus the light blocking region of the color filter is provided with only two color filters. The light blocking region overlapping two color filters is provided only in a region overlapping the pixel defining layer 380 on a plane, and one side of the light blocking region of the color filter is provided inward from the corresponding side of the pixel defining layer 380.

Only one color filter may be provided in a region other than the light blocking region of the color filter, and light of a color of the corresponding color filter is transmitted such that a light transmitting region of the color filter or a second opening OPCF of the light blocking region of the color filter is provided. The area of the second opening OPCF is provided larger than the opening OP of the pixel defining layer 380, and on a plane, the opening OP of the pixel defining layer 380 may be provided within the second opening OPCF of the light blocking region of the color filter.

The light blocking region of the color filter overlaps on a plane with the pixel defining layer 380, the spacer 385, and a plurality of sensing electrodes 540 and 541. In embodiments, the light blocking region of the color filter is provided inwardly by a set or certain distance g1 from one side of the spacer 385 relative to the corresponding side of the pixel defining layer 380, and the spacer 385 is also provided inwardly relative to one side of the light blocking region of the color filter. In embodiments, a plurality of sensing electrodes 540 and 541 are also covered on the plane by the light blocking region of the color filter. As a result, when viewed from the front of the display panel DP, the spacer 385 and the plurality of sensing electrodes 540 and 541 may not be visible due to the light blocking region of the color filter.

Depending on embodiments, the color filters 230R, 230G, and 230B may be replaced with a color conversion layer, or a color conversion layer may further be included. The color conversion layer may include quantum dots.

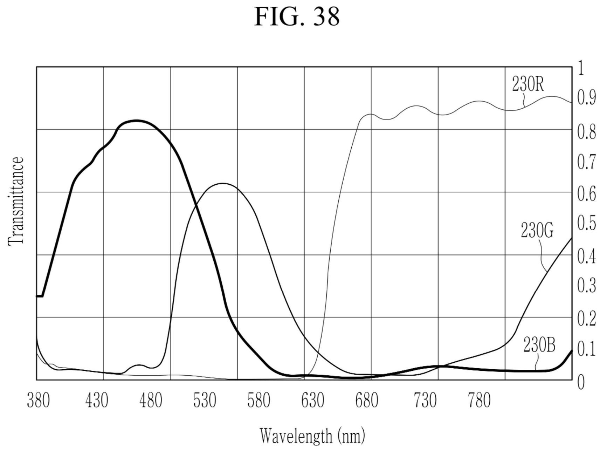

Hereinafter, it will be described that whether stacking two color filters can replace the role of the light blocking layer through FIG. 38.

FIG. 38 is a graph that shows transmittance according to a wavelength of the color filter.

FIG. 38 is a transmittance graph for a wavelength of each of the color filters 230R, 230G, and 230B, and light in the wavelength range indicated at a high level is transmitted. Referring to FIG. 38, it can be seen that the wavelength bands transmitted by the respective color filter 230R, 230G, and 230B have transmittances of less than 10%, and that when three or two color filters overlap, there is almost no wavelength band transmitted. Therefore, it can be confirmed that overlapping at least two color filters can replace the role of the light blocking layer, and that overlapping three color filters, as in FIG. 36, or overlapping two color filters, as in FIG. 37, can replace the light blocking layer.

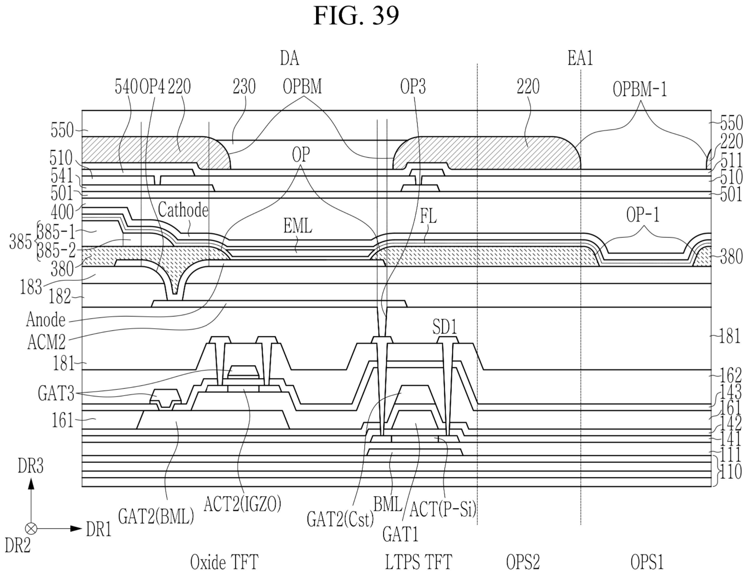

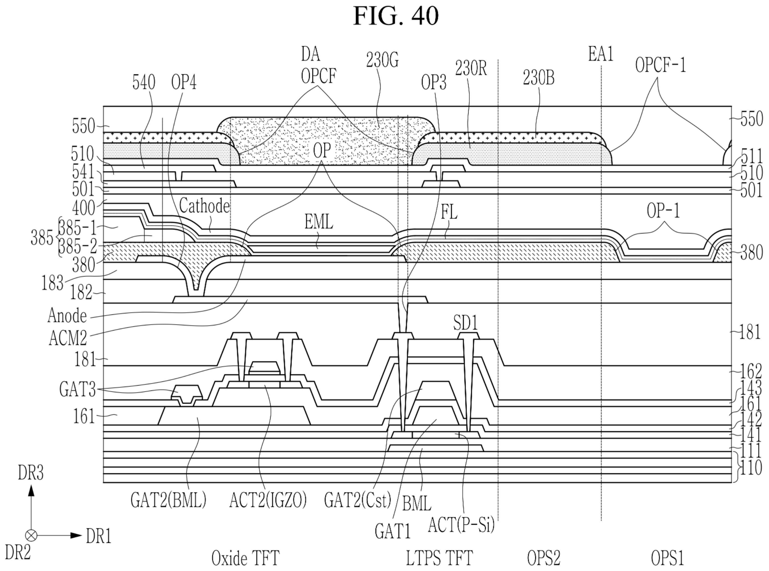

Hereinafter, referring to FIG. 39 and FIG. 40, a stacking structure of the display area DA and the first component area EA1 will be described in more detail.

FIG. 39 and FIG. 40 are cross-sectional views of a light emitting display device according to an embodiment.

FIG. 39 illustrates an embodiment including a light blocking layer 220, and FIG. 40 illustrates an embodiment in which a light blocking region of a color filter is provided by overlapping a blue color filter 230B and a red color filter 230R, instead of a light blocking layer 220.

First, the embodiment of FIG. 39 will be described in more detail.

A light emitting display device may be divided into a lower panel layer and a upper panel layer, and the lower panel layer is a portion where a light emitting diode and a pixel circuit portion, which form a pixel, are provided and may include an encapsulation layer 400 covering the light emitting diode and the pixel circuit portion. In embodiments, the pixel circuit portion include a second organic layer 182 and a third organic layer 183, and which imply a configuration of a lower portion of the pixel circuit portion, and the light emitting diode may imply a configuration, which is provided above the third organic layer 183 and below the encapsulation layer 400. A structure provided above the encapsulation layer 400 may correspond to the upper panel layer.

Referring to FIG. 39, a metal layer BML is on a substrate 110.

The substrate 110 may include a rigid material such as glass that does not bend, or a flexible material that can be bent such as plastic (e.g., polymer) and/or polyimide. In the embodiment of a flexible substrate, as illustrated in FIG. 39, it may have a double structure provided by a two-layer structure of polyimide and a barrier layer formed of an inorganic insulating material (e.g., an inorganic electrically insulating material) thereon.

The metal layer BML may be provided at a position that overlaps a channel of a driving transistor T1 among the subsequent first semiconductor layers, and is also called a lower shielding layer. The metal layer BML may include a metal such as copper (Cu), molybdenum (Mo), aluminum (Al), and titanium (Ti), and/or a metal alloy.

A buffer layer 111 covering the substrate 110 and the metal layer BML is on the substrate 110 and the metal layer BML. The buffer layer 111 serves to block or reduce penetration of an impurity element into a first semiconductor layer ACT(P-Si) and may be an inorganic insulation layer containing silicon oxide (SiOx) and/or silicon nitride (SiNx), silicon oxynitride (SiONx), and/or the like.

On the buffer layer 111, the first semiconductor layer ACT (P-Si) formed of a silicon semiconductor (e.g. polycrystalline semiconductor (P-Si)) is provided. The first semiconductor layer ACT (P-Si) includes a channel of a polycrystalline transistor LTPS TFT including the driving transistor T1, and a first region and a second region provided at both sides of the channel. In embodiments, the polycrystalline transistor LTPS TFT may include not only the driving transistor T1 but also various suitable transistors, such as a switching transistor and/or a compensation transistor. In embodiments, regions having conductive layer characteristics (e.g., electrically conductive layer characteristics) through plasma treatment and/or doping may be formed on both sides of the channel of the first semiconductor layer ACT (P-Si) and thus may serve as a first electrode and second electrode of a transistor.

A first gate insulation layer 141 may be on the first semiconductor layer ACT(P-Si). The first gate insulation layer 141 may be an inorganic insulation layer including silicon oxide (SiOx), silicon nitride (SiNx), and/or silicon oxynitride (SiONx).

A first gate conductive layer GAT1 including a gate electrode of the polycrystalline transistor LTPS TFT may be on the first gate insulation layer 141. In the first gate conductive layer GAT1, a first scan line and/or a light emission control line may be provided in addition to the gate electrode of the polycrystalline transistor LTPS TFT. The first gate conductive layer may include a metal such as copper (Cu), molybdenum (Mo), aluminum (Al), or titanium (Ti), and/or a metal alloy, and may be formed of a single layer or a plurality of layers.

After forming the first gate conductive layer GAT1, an exposed region of the first semiconductor layer may become conductive (e.g., electrically conductive) by performing a plasma treatment and/or a doping process. For example, the first semiconductor layer ACT (P-Si) covered by the first gate conductive layer GAT1 is not conductive (e.g., electrically conductive), and a part of the first semiconductor layer ACT (P-Si) that is not covered by the first gate conductive layer GAT1 may have the same characteristics as the conductive layer.

A second gate insulation layer 142 may be on the first gate conductive layer GAT1 and the first gate insulation layer 141. The second gate insulation layer 142 may be an inorganic insulation layer including silicon oxide (SiOx), silicon nitride (SiNx), and/or silicon oxynitride (SiONx).

A second gate conductive layer including one electrode GAT2(Cst) of a storage capacitor Cst and a lower shielding layer GAT2(BML) of an oxide transistor Oxide TFT may be on the second gate insulation layer 142. The lower shielding layer GAT2(BML) of the oxide transistor Oxide TFT is provided at a bottom of each channel of the oxide transistor Oxide TFT and may serve to shield from light or electromagnetic interference (EMI) provided to the channel from the bottom. In embodiments, the one electrode GAT2(Cst) of the storage capacitor Cst forms the storage capacitor Cst by overlapping the gate electrode GAT1 of the driving transistor T1. Depending on embodiments, the second gate conductive layer may further include a scan line, a control line, and/or a voltage line. The second gate conductive layer may include a metal such as copper (Cu), molybdenum (Mo), aluminum (Al), or titanium (Ti), and/or a metal alloy, and may be formed of a single layer or a plurality of layers.

A first interlayer insulation layer 161 may be on the second gate conductive layer. The first interlayer insulation layer 161 may include an inorganic insulation layer including silicon oxide (SiOx), silicon nitride (SiNx), and/or silicon oxynitride (SiONx), and may an inorganic insulating material may be provided to be thick depending on embodiments.

An oxide semiconductor layer ACT2(IGZO) including the channel, the first region, and the second region of the oxide transistor Oxide TFT may be on the first interlayer insulation layer 161.

A third gate insulation layer 143 may be on the oxide semiconductor layer ACT2(IGZO). The third gate insulation layer 143 may be on a front surface of the oxide semiconductor layer ACT2(IGZO) and the first interlayer insulation layer 161. The third gate insulation layer 143 may include an inorganic insulation layer including silicon oxide (SiOx), silicon nitride (SiNx), and/or silicon oxynitride (SiONx).

A third gate conductive layer GAT3 including a gate electrode of the oxide transistor Oxide TFT may be on the third gate insulation layer 143. The gate electrode of the oxide transistor Oxide TFT may overlap the channel. The third gate conductive layer GAT3 may further include a scan line and/or a control line, and additionally, may include a connection electrode connected with the lower shielding layer GAT2(BML) of the oxide transistor Oxide TFT. The third gate conductive layer GAT3 may include a metal such as copper (Cu), molybdenum (Mo), aluminum (Al), or titanium (Ti), and/or a metal alloy, and may be formed of a single layer or a plurality of layers.

A second interlayer insulation layer 162 may be on the third gate conductive layer GAT3. The second interlayer insulation layer 162 may have a single-layer or multi-layer structure. The second interlayer insulation layer 162 may include an inorganic insulation material (e.g., an inorganic electrical insulating material) such as silicon oxide (SiOx), silicon nitride (SiNx), and/or silicon oxynitride (SiONx), and/or may include an organic insulating material (e.g., an organic electrically insulating material) depending on embodiments.

A first data conductive layer SD1 including a connection electrode that may be connected with the first region and the second region of each of the polycrystalline transistor LTPS TFT and the oxide transistor Oxide TFT may be on the second interlayer insulation layer 162. The first data conductive layer SD1 may include a metal such as copper (Cu), molybdenum (Mo), aluminum (Al), and/or titanium (Ti), and/or a metal alloy, and may be formed of a single layer or a plurality of layers.

A first organic layer 181 may be on the first data conductive layer SD1. The first organic layer 181 may be an organic insulator including an organic material, and as the organic material, a material selected from the group consisting of polyimide, polyamide, acryl resin, benzocyclobutene, and phenol resin may be included.

A second data conductive layer including an anode connection electrode ACM2 may be on the first organic layer 181. The second data conductive layer may include a data line and/or a driving voltage line. The second data conductive layer SD2 may include a metal such as aluminum (Al), copper (Cu), molybdenum (Mo), and/or titanium (Ti) and/or a metal alloy, and may be formed of a single layer or a plurality of layers.

A second organic layer 182 and a third organic layer 183 are on the second data conductive layer, and an anode connecting opening OP4 is provided in the second organic layer 182 and the third organic layer 183. The anode connection electrode ACM2 is electrically connected with the anode Anode through the anode connecting opening OP4. The second organic layer 182 and the third organic layer 183 may be an organic insulator (e.g., an organic electrical insulator), and may include one or more materials selected from the group consisting of polyimide, polyamide, acryl resin, benzocyclobutene, and phenol resin. Depending on embodiments, the third organic layer 183 may be omitted.

A pixel defining layer 380 covering at least a part of the anode Anode, while including an opening OP exposing the anode Anode may be on the anode Anode. The pixel defining layer 380 may be a black pixel defining layer formed of an organic material having a black color to prevent or reduce reflection of externally applied light back to the outside, and may be formed of a transparent organic material depending on embodiments. Therefore, depending on embodiments, the pixel defining layer 380 may include an organic material of negative type black color and may include a black color pigment.

A spacer 385 is on the pixel defining layer 380. The spacer 385 may include a first portion 385-1 provided in a high and narrow region and a second portion 385-2 provided in a low and wide region. Unlike the pixel defining layer 380, the spacer 385 may be formed of a transparent organic insulating material (e.g., a transparent organic electrically insulating material). Depending on embodiments, the spacer 385 may be formed of a positive type (or kind) of transparent organic material.

A function layer FL and a cathode Cathode are sequentially on the anode Anode, the function layer FL and the cathode Cathode may be provided in all regions in the display area DA and the first component area EA1. A light emitting layer EML is between the function layers FL, and the light emitting layer EML may only be provided within the opening OP of the pixel defining layer 380. Hereinafter, the function layer FL and the light emitting layer EML may be combined to form an intermediate layer. The function layer FL may include at least one layer of auxiliary layers such as an electron injection layer, an electron transport layer, a hole transport layer, and a hole injection layer, and the hole injection layer and the hole transport layer may be provided below the light emitting layer EML, and the electron transport layer and the electron injection layer may be provided above the light emitting layer EML.

The encapsulation layer 400 is on the cathode Cathode. The encapsulation layer 400 includes at least one inorganic layer and at least one organic layer, and depending on embodiments, the encapsulation layer 400 may have a triple-layered structure including a first inorganic encapsulation layer, an organic encapsulation layer, and a second inorganic encapsulation layer. The encapsulation layer 400 may be provided to protect the light emitting layer EML from moisture and/or oxygen that may inflow from the outside. Depending on embodiments, the encapsulation layer 400 may include a structure in which inorganic layers and organic layers are further sequentially stacked.

Sensing insulation layers 501, 510, and 511 and a plurality of sensing electrodes 540 and 541 are provided to sense a touch on the encapsulation layer 400. In the embodiment of FIG. 39, a touch is detected in a capacitive type (or kind) using two sensing electrodes 540 and 541.

In embodiments, a first sensing insulation layer 501 is on the encapsulation layer 400, and the plurality of sensing electrodes 540 and 541 are on the first sensing insulation layer 501. The plurality of sensing electrodes 540 and 541 may be insulated (e.g., electrically insulated) from each other, while providing the second sensing insulation layer 510 therebetween, and may be electrically connected with each other through an opening provided in the second sensing insulation layer 510. In embodiments, the sensing electrodes 540 and 541 may include a metal such as aluminum (Al), copper (Cu), silver (Ag), gold (Au), molybdenum (Mo), titanium (Ti), and/or tantalum (Ta), and/or a metal alloy thereof and may be formed of a single layer or a plurality of layers. A third sensing insulation layer 511 is on the sensing electrode 540.

A light blocking layer 220 and color filters 230R, 230G, and 230B are on the third sensing insulation layer 511.

The light blocking layer 220 may be provided to overlap the sensing electrodes 540 and 541 on a plane. The light blocking layer 220 includes a second opening OPBM, and the second opening OPBM of the light blocking layer 220 overlaps the opening OP of the pixel defining layer 380 on a plane. In embodiments, the second opening OPBM of the light blocking layer 220 may be provided wider than the opening OP of the pixel defining layer 380. As a result, the anode Anode that overlaps the opening OP of the pixel defining layer 380 (e.g., exposed by the opening OP of the pixel defining layer 380) may have a structure that is not covered on the plane by the light blocking layer 220. This is to ensure that the anode Anode and the light emitting layer EML that can display an image are not covered by the light blocking layer 220 and the sensing electrodes 540 and 541. In embodiments, the light blocking layer 220 has a structure that overlaps the anode connecting opening OP4 on a plane, but does not overlap the opening OP3 of the first organic layer 181 on a plane.

Color filters 230R, 230G, and 230B are on the sensing insulation layer 501, 510, and 511 and the light blocking layer 220. Depending on embodiments, the color filters 230R, 230G, and 230B may be replaced with a color conversion layer, or a color conversion layer may further be included. The color conversion layer may include quantum dots.

A planarization layer 550 that covers the color filters 230R, 230G, and 230B may be on the color filters 230R, 230G, and 230B, and depending on embodiments, a low-refractive layer and an additional planarization layer may be on the planarization layer 550 to improve frontal visibility and light output efficiency of the display device. Light may be refracted and emitted toward the front by the additional planarization layer having low refractive index and high refractive index characteristics. Depending on embodiments, the planarization layer 550 may be omitted and the low-refractive layer and the additional planarization layer may be directly on the color filter 230.

In the present embodiment, a polarizing plate may not be included above the planarization layer 550. For example, the polarizing plate may serve to prevent or reduce display quality deterioration when external light is incident and visible to a user while being reflected from the anode Anode and/or the like. In the present embodiment, the pixel defining layer 380 covers a side surface of the anode Anode to reduce the amount of reflection from the anode Anode, and the light blocking layer 220 is also provided to reduce the amount of light incident, thereby already including a structure that prevents or reduces deterioration of display quality due to reflection. Therefore, there is no need to separately form a polarizing plate on the front surface of the display panel DP.

In FIG. 39, a cross-sectional structure of the first component area EA1 in which light can be additionally transmitted through a portion of the display area DA is illustrated in addition to the stacking structure of the display area DA.

In FIG. 39, the first component area EA1 is divided into a first optical sensor region OPS1 (referred to as a transmissive optical sensor region) and a second optical sensor region OPS2 (referred to as a non-transmissive optical sensor region). In embodiments, additional openings OP-1 and OPBM-1 are respectively provided in the first optical sensor region OPS1 to prevent or reduce overlapping with the pixel defining layer 380 and the light blocking layer 220 on a plane such that light may pass through the first optical sensor region OPS1. The second optical sensor region OPS2 is a region provided to overlap the pixel defining layer 380 and the light blocking layer 220 on a plane such that light does not transmit therethrough. The first optical sensor region OPS1 and the second optical sensor region OPS2 of the first component area EA1 both may not include a layer that blocks light, such as a metal layer or a semiconductor layer. For reference, a first optical element ES1 (refer to FIG. 2) is on a rear surface of the first component area EA1, and a front surface of the light emitting display device may be detected through the first optical sensor region OPS1 provided in the first component area EA1.

A layered structure of the first component area EA1 will be further described hereinafter.

A buffer layer 111, which is an inorganic insulation layer, is on the substrate 110, and a first gate insulation layer 141 and a second gate insulation layer 142, which are inorganic insulation layers (e.g., inorganic electrically insulating layers), are sequentially provided. In embodiments, a first interlayer insulation layer 161, a third gate insulation layer 143, and a second interlayer insulation layer 162, which are inorganic insulation layers (e.g., inorganic electrically insulating layers), are sequentially stacked on the second gate insulation layer 142.

A first organic layer 181, a second organic layer 182, and a third organic layer 183, which are organic insulators (e.g., organic electrical insulators), are sequentially stacked on the second interlayer insulation layer 162.

The function layer FL may be on the third organic layer 183, and the cathode Cathode may be on the function layer FL.

The encapsulation layer 400 is on the cathode Cathode, and the sensing insulation layers 501, 510, and 511 are on the encapsulation layer 400. The encapsulation layer 400 may have a triple-layered structure that sequentially includes an inorganic encapsulation layer, an organic encapsulation layer, and an inorganic encapsulation layer. In embodiments, the sensing insulation layers 501, 510, and 511 may all be inorganic insulation layers (e.g., inorganic electrically insulating layers).

The planarization layer 550 may be on the sensing insulation layers 501, 510, and 511.

In such a first component area EA1, a metal layer, a first semiconductor layer, a first gate conductive layer, a second gate conductive layer, an oxide semiconductor layer, a third gate conductive layer, a first data conductive layer, a second data conductive layer, and an anode are not provided. In embodiments, the light emitting layer EML and the sensing electrodes 540 and 541 are not provided.

In embodiments, in the first optical sensor region OPS1 of the first component area EA1, the additional openings OP-1 and OPBM-1 are respectively provided in the pixel defining layer 380 and the light blocking layer 220 such that the pixel defining layer 380 and the light blocking layer 220 may not be provided. As a result, light can be passed through the first optical sensor region OPS1. The second optical sensor region OPS2 in the first component area EA1 may have a structure in which light is not transmitted because the additional openings OP-1 and OPBM-1 are not provided and overlaps with the pixel defining layer 380 and the light blocking layer 220.

In the above, the embodiment in which a total of three organic layers are provided, and the anode connecting openings are provided in the second organic layer and the third organic layer. However, at least two organic layers may be provided, in which embodiment the anode connecting opening may be provided in an upper organic layer provided farther away from the substrate, and a lower organic layer opening may be provided in the lower organic layer.

Hereinafter, referring to FIG. 40, an embodiment in which a light blocking region of a color filter is provided by overlapping the blue color filter 230B and the red color filter 230R instead of the light blocking layer 220 will be described.

In FIG. 40, the third sensing insulation layer 511 and the structure below the third sensing insulation layer 511 is the same as the structure of FIG. 29, and thus an upper structure of the third sensing insulation layer 511, which is a portion different from FIG. 39 will be described in more detail.

The color filters 230R, 230G, and 230B are on the third sensing insulation layer 511. In the embodiment of FIG. 40, a light blocking layer is not included, and the overlapped color filters 230R and 230B serve as the light blocking layer, and the overlapped color filter 230R and 230B may overlap the sensing electrodes 540 and 541 on a plane. The overlapped color filters 230R and 230B include second openings OPCF, and the second openings OPCF of the overlapped color filters 230R and 230B overlap the opening OP of the pixel defining layer 380 on a plane. In embodiments, the second openings OPCF of the overlapped color filters 230R and 230B may be provided wider than the opening OP of the pixel defining layer 380. As a result, an anode Anode overlapped (for example, exposed by the opening OP of the pixel defining layer 380) with the opening OP of the pixel defining layer 380 may have a structure that is not covered by the overlapped color filters 230R and 230B on a plane. This is to prevent the anode Anode and the light emitting layer EML, which can display an image, from being covered by the overlapped color filters 230R and 230B and the sensing electrodes 540 and 541. In embodiments, the overlapped color filters 230R and 230B are overlapped with the anode connecting opening OP4 on a plane.

One color filter may be provided in the second opening OPCF of the overlapped color filters 230R and 230B, and in FIG. 40, the green color filter 230G is provided. Depending on embodiments, the color filters 230R, 230G, and 230B may be replaced with a color conversion layer, or a color conversion layer may further be included. The color conversion layer may include quantum dots.

A planarization layer 550 that covers the color filters 230R, 230G, and 230B may be on the color filters 230R, 230G, and 230B, and depending on embodiments, a low-refractive layer and an additional planarization layer may be on the planarization layer 550 to improve frontal visibility and light output efficiency of the display device. Depending on embodiments, the planarization layer 550 may be omitted, and the refractive layer and additional planarization layer may be directly on the color filter.

In the embodiment of FIG. 40, a polarizing plate is not included above the planarization layer 550. For example, the polarizing plate may serve to prevent or reduce display quality deterioration when external light is incident and visible to a user while being reflected from the anode Anode and/or the like. In the present embodiment, the pixel defining layer 380 covers a side surface of the anode Anode to reduce the amount of reflection from the anode Anode, and the light blocking layer 220 is also provided to reduce the amount of light incident, thereby already including a structure that prevents or reduces deterioration of display quality due to reflection. Therefore, there is no need to separately form a polarizing plate on the front surface of the display panel DP.

A cross-sectional structure of the first component area EA1 according to the embodiment of FIG. 40 will be the same as described below.

The first component area EA1 is divided into a first optical sensor region OPS1 and a second optical sensor region OPS2. Here, the first optical sensor region OPS1 is a region where the additional openings OP-1 and OPCF-1 are respectively provided not to overlap the light blocking region of the color filter on a plane, provided by overlapping the pixel defining layer 380 and at least two color filters such that light can pass. The second optical sensor region OPS2 is a region provided to overlap the light blocking region of the color filter on a plane, provided by overlapping the pixel defining layer 380 and at least two color filters such that light cannot pass. The first optical sensor region OPS1 and the second optical sensor region OPS2 of the first component area EA1 both may not include a layer blocking light, such as a metal layer, a semiconductor layer, and/or the like. For reference, a first optical element ES1 (refer to FIG. 2) is on a rear surface of the first component area EA1, and a front surface of the light emitting display device may be detected through the first optical sensor region OPS1 provided in the first component area EA1.

A layered structure of the first component area EA1 will be described hereinafter.

A buffer layer 111, which is an inorganic insulation layer (e.g., an inorganic electrically insulating layer), is on the substrate 110, and a first gate insulation layer 141 and a second gate insulation layer 142, which are inorganic insulation layers (e.g., inorganic electrically insulating layers), are sequentially provided. In embodiments, a first interlayer insulation layer 161, a third gate insulation layer 143, and a second interlayer insulation layer 162, which are inorganic insulation layers (e.g., inorganic electrically insulating layers), are sequentially stacked on the second gate insulation layer 142.

A first organic layer 181, a second organic layer 182, and a third organic layer 183, which are organic insulators (e.g., organic electrical insulators), are sequentially stacked on the second interlayer insulation layer 162.

The function layer FL may be on the third organic layer 183, and the cathode Cathode may be on the function layer FL.

The encapsulation layer 400 is on the cathode Cathode, and the sensing insulation layers 501, 510, and 511 are on the encapsulation layer 400. The encapsulation layer 400 may have a triple-layered structure that sequentially includes an inorganic encapsulation layer, an organic encapsulation layer, and an inorganic encapsulation layer. In embodiments, the sensing insulation layers 501, 510, and 511 may all be inorganic insulation layers.

The planarization layer 550 may be on the sensing insulation layers 501, 510, and 511.

In such a first component area EA1, a metal layer, a first semiconductor layer, a first gate conductive layer, a second gate conductive layer, an oxide semiconductor layer, a third gate conductive layer, a first data conductive layer, a second data conductive layer, and/or an anode are not provided. In embodiments, the light emitting layer EML and the sensing electrodes 540 and 541 are not provided.

In embodiments, in the first optical sensor region OPS1 of the first component area EA1, the additional openings OP-1 and OPCF-1 are respectively provided in the pixel defining layer 380 and the light blocking region of the color filter such that the pixel defining layer 380 and the color filter may not be provided. As a result, light can be passed through the first optical sensor region OPS1. The second optical sensor region OPS2 in the first component area EA1 may have a structure in which light is not transmitted because the additional openings OP-1 and OPCF-1 are not provided and overlaps with the pixel defining layer 380 and the light blocking region of the color filter.

In the above, the embodiment in which a total of three organic layers are provided, and the anode connecting openings are provided in the second organic layer and the third organic layer. In embodiments, at least two organic layers may be provided, in which provided the anode connecting opening may be provided in an upper organic layer provided farther away from the substrate, and a lower organic layer opening may be provided in the lower organic layer.

As discussed, embodiment of the invention may provide a light emitting display device comprising a display area in which a plurality of repeating unit pixels (or repeating unit pixels) are repeatedly provided, wherein: the repeating unit pixel comprises a plurality of minimum unit pixels, the minimum unit pixel comprises at least one red subpixel, at least one green subpixel, and at least one blue subpixel, the green subpixel, the red subpixel, and the blue subpixel correspond to a first opening provided in a pixel defining layer and a second opening provided above the first opening while corresponding to the first opening, at least one of the first opening and the second opening has an elliptical shape in planar shape, and the repeating unit pixel is formed of minimum unit pixels provided in a 2x2 array.

Hence, the repeating unit pixels comprise 2x2 array of minimum unit pixels, with the minimum unit pixels comprising at least one red subpixel, at least one green subpixel, and at least one blue subpixel, the green subpixel.

The repeating unit pixels are repeatedly provided to make up the pixels of the light emitting display device.

The minimum unit pixel may be formed of four of the green subpixels, two of the red subpixels, and two of the blue subpixels. A first square may be defined by connecting the four green subpixels with horizontal and vertical straight lines, and a second square may be defined by connecting the two red subpixels and the two blue subpixels with horizontal and vertical straight lines, when considered in plan view.

The minimum unit pixel may be formed of one green subpixel, one red subpixel, and one blue subpixel. A triangle may be defined by connecting the one green subpixel, the one red subpixel, and the one blue subpixel in a straight line, when considered in plan view.

Embodiments may provide an electronic device comprising a light emitting display device according to any of the above mentioned embodiments.

Although embodiments of the present disclosure has been described in more detail above, the scope of the present disclosure is not limited thereto, and various suitable modifications and improvements made by a person of ordinary skill in the art using the concepts of the present disclosure defined in the following claims, and equivalents thereof, also fall within the scope of the present disclosure.

### Description of symbols

| | | | |
|---|---|---|---|
| 220: | light blocking layer | 380: | pixel defining layer |
| OP, OPr, OPg, OPb: | opening of pixel defining layer | | |
| OPBM, OPBMr, OPBMg, OPBMb: | second opening of light blocking layer | | |
| 230R, 230G, 230B: | color filter | OPCF: | second opening of color filter |
| Anode: | anode | Cathode: | cathode |
| EML: | light emitting layer | FL: | function layer |
| 1000: | display device | DP: | display panel |
| 110: | substrate | 180, 181, 182, 183: | organic layer |
| 141, 142, 143: | gate insulation layer | | |
| 161, 162: | interlayer insulation layer | | |
| 385, 385-1, 385-2: | spacer | | |
| 400, 401, 402, 403: | encapsulation layer | | |
| 501, 510, 511: | sensing insulation layer | | |
| 540, 541: | sensing electrode | | |
| 550: | planarization layer | DA, DA1-1, DA1-2: | display area |
| EA, EA1, EA2: | component area | | |

## Claims

1. A light emitting display device comprising a display area in which a plurality of repeating unit pixels are repeatedly provided, wherein:
the repeating unit pixel comprises a plurality of minimum unit pixels,
the minimum unit pixel comprises at least one red subpixel, at least one green subpixel, and at least one blue subpixel,
the green subpixel, the red subpixel, and the blue subpixel correspond to a first opening provided in a pixel defining layer and a second opening provided above the first opening while corresponding to the first opening,
at least one of the first opening and the second opening has an elliptical shape in planar shape, and
the repeating unit pixel is formed of minimum unit pixels provided in a 2x2 array.

2. The light emitting display device of claim 1, wherein:
the minimum unit pixel is formed of four of the green subpixels, two of the red subpixels, and two of the blue subpixels.

3. The light emitting display device of claim 2, wherein:
a first square is defined by connecting the four green subpixels with horizontal and vertical straight lines, and a second square is defined by connecting the two red subpixels and the two blue subpixels with horizontal and vertical straight lines, when considered in plan view.

4. The light emitting display device of claim 3, wherein:
the red subpixel or the blue subpixel is provided at a center of the first square defined by the four green subpixels, and the green subpixel is provided at a center of the second square defined by the two red subpixels and the two blue subpixels.

5. The light emitting display device of claim 4, wherein:
the first opening and the second opening, which correspond to the green subpixel, the red subpixel, and the blue subpixel respectively, have an elliptical shape in planar shape;
a major axis direction of the second opening has an angular difference of 45*n degrees, where n is a natural number greater than or equal to 1 and less than or equal to 8, from a major axis direction of an adjacent second opening of the same color.

6. The light emitting display device of claim 5, wherein:
in the repeating unit pixel, the second opening corresponding to the red subpixel and the second opening corresponding to the blue subpixel have a major axis direction angle difference of 90 degrees and are provided alternately along a single diagonal direction.

7. The light emitting display device of claim 6, wherein:
in the repeating unit pixel, the major axis directions of the second opening corresponding to the red subpixel and the second opening corresponding to the blue subpixel are provided with directions of 0 degree and 90 degrees and 45 degrees and 135 degrees alternately along a single diagonal direction.

8. The light emitting display device of claim 7, wherein:
in the repeating unit pixel, among the second openings corresponding to the green subpixel, second openings having a 90 degree difference in the major axis direction are provided alternately along the horizontal direction or the vertical direction.

9. The light emitting display device of claim 8, wherein:
in the repeating unit pixel, the major axis direction angles of the second opening corresponding to the green subpixel are provided alternately along the horizontal direction or the vertical direction, with directions of 0 degree and 90 degrees and 45 degrees and 135 degrees.

10. The light emitting display device of claim 1, wherein:
the minimum unit pixel is formed of one green subpixel, one red subpixel, and one blue subpixel.

11. The light emitting display device of claim 10, wherein:
a triangle is defined by connecting the one green subpixel, the one red subpixel, and the one blue subpixel in a straight line, when considered in plan view.

12. The light emitting display device of claim 11, wherein:
the first opening and the second opening, which correspond to the green subpixel, the red subpixel, and the blue subpixel respectively, have an elliptical shape in planar shape, and
the major axis direction of the second opening has an angular difference of 45*n degrees, where n is a natural number greater than or equal to 1 and less than or equal to 8, from a major axis direction of an adjacent second opening of the same color;
optionally wherein: in the repeating unit pixel, among the second openings corresponding to the red subpixel, the green subpixel, and the blue subpixel, second openings having a 90 degree difference in the major axis direction are provided alternately along the horizontal direction or the vertical direction, when considered in plan view;
further optionally wherein: in the repeating unit pixel, the major axis direction angles of the second opening corresponding to the red subpixel, the green subpixel, and the blue subpixel are provided alternately along the horizontal direction or the vertical direction, with directions of 0 degree and 90 degrees and 45 degrees and 135 degrees, when considered in plan view.

13. The light emitting display device claim 1, wherein:
at least one of the first opening and the second opening has a circular shape in planar shape.

14. The light emitting display device of claim 1, wherein:
the second opening is on the light blocking layer that is provided above the pixel defining layer, or on a light blocking region of an overlapping color filter.

15. An electronic device comprising a light emitting display device,
wherein the light emitting display device is according to any one of claims 1 to 14.
